(19) Europäisches Patentamt
European Patent Office
Office européen des brevets

(11) EP 3 707 529 B1

(12) **FASCICULE DE BREVET EUROPEEN**

(45) Date de publication et mention de la délivrance du brevet:
**18.10.2023 Bulletin 2023/42**

(21) Numéro de dépôt: **18762329.3**

(22) Date de dépôt: **07.09.2018**

(51) Classification Internationale des Brevets (IPC):
***G01S 17/08*** (2006.01) ***G01S 7/40*** (2006.01)
***H01Q 3/26*** (2006.01) ***G01R 29/10*** (2006.01)
***G01S 7/02*** (2006.01) ***H01Q 3/46*** (2006.01)
***H01Q 21/06*** (2006.01)

(52) Classification Coopérative des Brevets (CPC):
**G01S 17/08; H01Q 3/2676;** G01R 29/10;
G01S 7/021; G01S 7/4082

(86) Numéro de dépôt international:
**PCT/EP2018/074121**

(87) Numéro de publication internationale:
**WO 2019/091625 (16.05.2019 Gazette 2019/20)**

(54) **DISPOSITIF DE STIMULATION RADIOÉLECTRIQUE PAR PANNEAU RAYONNANT AUTORÉFÉRENCE**

VORRICHTUNG ZUR RADIOELEKTRISCHEN STIMULATION DURCH EINE SELBSTREFERENZIERTE STRAHLUNGSPLATTE

DEVICE FOR RADIOELECTRIC STIMULATION BY SELF-REFERENCED RADIANT PANEL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **07.11.2017 FR 1701141**

(43) Date de publication de la demande:
**16.09.2020 Bulletin 2020/38**

(73) Titulaire: **Thales**
**92400 Courbevoie (FR)**

(72) Inventeurs:
- **JAHAN, Daniel**
  **29238 Brest Cedex 3 (FR)**
- **MAZEAU, Thierry**
  **33700 Merignac (FR)**
- **FORMONT, Stéphane**
  **78851 Elancourt (FR)**

(74) Mandataire: **Atout PI Laplace**
**Immeuble "Visium"**
**22, avenue Aristide Briand**
**94117 Arcueil Cedex (FR)**

(56) Documents cités:
**WO-A1-2015/028091 FR-A1- 2 695 759**

- **MODESTO E GODINEZ ET AL: "RF Characterization of Zero-Biased Photodiodes", JOURNAL OF LIGHTWAVE TECHNOLOGY, IEEE SERVICE CENTER, NEW YORK, NY, US, vol. 26, no. 24, 15 décembre 2008 (2008-12-15), pages 3829-3834, XP011241689, ISSN: 0733-8724, DOI: 10.1109/JLT.2008.927794**
- **MARK DORSEY W ET AL: "Design and Performance of Frequency Selective Surface With Integrated Photodiodes for Photonic Calibration of Phased Array Antennas", IEEE TRANSACTIONS ON ANTENNAS AND PROPAGATION, IEEE SERVICE CENTER, PISCATAWAY, NJ, US, vol. 58, no. 8, 1 août 2010 (2010-08-01), pages 2588-2593, XP011309298, ISSN: 0018-926X**
- **PAEK E G ET AL: "Photonic In-Situ Calibration of a Phased Array Antenna Using Planar Lightwave Circuit", MICROWAVE PHOTONICS, 2005. MWP 2005. INTERNATIONAL TOPICAL MEETING ON SEOUL, KOREA 12-14 OCT. 2005, PISCATAWAY, NJ, USA,IEEE, 12 octobre 2005 (2005-10-12), pages 351-354, XP010890701, ISBN: 978-89-950043-3-3**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

- LEVINE E ET AL: "Fiber optic networks for phased arrays", ELECTRICAL AND ELECTRONICS ENGINEERS IN ISRAEL, 1991. PROCEEDINGS., 17 TH CONVENTION OF TEL AVIV, ISRAEL 5-7 MARCH 1, NEW YORK, NY, USA,IEEE, US, 5 mars 1991 (1991-03-05), pages 390-393, XP010041253, DOI: 10.1109/EEIS.1991.217685 ISBN: 978-0-87942-678-1
- N. SHIMIZU ET AL: "Photodiode-integrated microstrip antenna array for subterahertz radiation", IEEE PHOTONICS TECHNOLOGY LETTERS., vol. 18, no. 6, 1 mars 2006 (2006-03-01), pages 743-745, XP055411789, US ISSN: 1041-1135, DOI: 10.1109/LPT.2006.871131

## Description

*DOMAINE DE L' INVENTION*

Le domaine technique de l'invention est celui des antennes à formation de faisceaux réalisées en particulier en état-solide.

Le domaine d'exploitation de l'invention est celui du test et des stimulations de systèmes de réception radioélectrique en particulier une fois installé sur leur plate-forme porteuse, comme par exemple les Détecteurs de radars ou les Intercepteurs de communications.

*CONTEXTE DE L' INVENTION - ART ANTERIEUR*

Pour stimuler un système de réception radioélectrique une fois installé sur sa plate-forme porteuse sans y apporter de modification, une solution consiste à recourir à une génération classique d'un signal radioélectrique à distance dudit système de réception radioélectrique. La distance impose alors un certain niveau de puissance rayonnée en direction dudit système de réception radioélectrique, et les solutions similaires à celles des émetteurs opérationnels dont lesdits systèmes de réception radioélectrique sont faits pour recevoir les signaux, sont naturellement candidates.

On retombe par exemple sur des architectures de radars limitées à l'émission (la réception n'ayant pas d'intérêt ici puisque seul le signal émis est recherché) et, en particulier, sur des architectures de radars à balayage électronique, qui présente l'intérêt de ne pas nécessiter de moyens mécaniques pour pointer le faisceau de l'antenne de test vers le système de réception radioélectrique à tester.

Ces architectures définissent des dispositifs généralement compacts. Cependant pour certaines applications, il est parfois utile de pouvoir désolidariser la partie générant le signal de stimulation avec sa loi de phase, de la partie qui en assure le rayonnement, et ce tout conservant, autant que possible, pour cette dernière une structure simple car, pour les besoins de certaines applications, elle peut être multipliée.

Dans ce contexte, un problème technique consiste à trouver une solution matérielle permettant le transport du signal de stimulation avec sa loi de phase de façon à obtenir l'émission du signal radioélectrique désiré dans la direction voulue.

Dans la mesure où les dispositifs de stimulation existants sont très généralement compacts, l'état de l'art ne propose pas de solution permettant la désolidarisation de la partie génération du signal de stimulation de la partie rayonnante.

Les dispositifs connus sont en particulier basés sur des architectures telles que celles illustrées par les figures 1 et 2.

La figure 1 représente une structure classique permettant de générer une loi de phase au moyen de déphaseurs contrôlés 11 reliés à des modules d'émission 12.

La figure 2 représente une structure classique permettant de générer une loi de phase directement au moyen de générateurs de formes d'onde 21 contrôlés également en phase (structure MIMO pour *multiple inputs multiple outputs*) reliés à des modules d'émission 12.

Une solution pour pouvoir désolidariser la partie générant le signal de stimulation avec sa loi de phase, de la partie qui en assure le rayonnement consiste, comme l'illustre la figure 3, à scinder en deux la structure des modules d'émission qui assurent le rayonnement du signal de stimulation, au niveau de la sortie des signaux déphasés, juste à l'entrée de l'étage d'amplification de puissance.

Cette coupure conduit à regrouper matériellement, en un premier ensemble générateur de signaux 31 les éléments qui réalisent l'ensemble des signaux déphasés qui portent la loi de phase du signal de stimulation à rayonner, et à regrouper matériellement en un second ensemble 32, distant du premier, les éléments qui réalisent l'amplification en puissance des signaux et leur rayonnement. Une telle solution, illustrée par la figure 3, est, en particulier, indifféremment applicable aux structures illustrées par les figures 1 et 2.

Cependant l'emploi d'une telle solution implique de maîtriser l'acheminement des signaux hyperfréquence produit par le premier ensemble 31, signaux pouvant atteindre plusieurs dizaines de GHz, vers le second ensemble 32, les deux ensembles pouvant être éloignés l'un de l'autre de plusieurs dizaines de mètres. Cet acheminement 33 doit en effet être réalisé sans perte ou altération des phases relatives des signaux véhiculés.

L'acheminement de signaux à très haute fréquence d'un équipement vers un autre équipement distant au moyen de liaisons par fibres optiques, étant bien connu, une solution pour acheminer les signaux hyperfréquence produit par le premier ensemble 31 vers le second ensemble 32, consiste naturellement en l'utilisation d'un déport 41 par fibres optiques. Une telle solution est illustrée par la figure 4.

Une telle solution peut être mise en oeuvre selon différents variantes connues de l'état de l'art. En particulier il est possible d'utiliser un nombre de fibres optiques inférieur au nombre de signaux à acheminer. Pour cela, plusieurs signaux portés par des ondes laser de longueurs d'onde différentes peuvent être multiplexés sur une même fibre optique ;

ce multiplexage en longueur d'onde impliquant évidemment un démultiplexage à l'arrivée.

Cependant, le défaut d'une telle solution est de maintenir malgré tout un lien physique entre les deux unités matérielles 31 et 32, ce qui constitue une difficulté pour certaines applications.

Une autre solution basée sur un déport optique entre les deux ensembles 31 et 32 consiste, comme l'illustre la figure 5, à acheminer les signaux produits par l'ensemble 31 au travers d'un faisceau laser composite chaque composant $s_{k,l}(t)$ du signal de stimulation rayonné étant porté par une onde laser de longueur d'onde distincte. Le faisceau laser est dirigé vers un ensemble de récepteurs optoélectroniques disposés dans un plan, une matrice de photodiodes par exemple, chaque onde laser étant destiné à être reçue par un récepteur optoélectronique dédié, relié au module d'émission $e_i$ destiné à rayonner ladite composante.

Cependant, pour pouvoir garantir le maintien de la loi de phase désirée, un tel moyen doit généralement être accompagné de moyens permettant de mesurer et de corriger le biais de phase introduit par la distance et la direction d'incidence $(D,\alpha,\beta)$ du faisceau laser composite par rapport au plan des capteurs optoélectroniques, de façon à transmettre à chacun des modules d'émission un signal présentant le déphasage requis pour former le signal rayonné. L'ajout de tels moyen rend plus complexe la mise en oeuvre d'une telle solution et réduit les avantages qu'elle procure en termes d'élimination du lien physique entre l'ensemble qui génère les signaux constituant le signal de stimulation et l'ensemble qui amplifie et rayonne ces signaux.

Un document WO 2015/028091 divulgue un générateur de signal pour une antenne à balayage électronique.

Un but de l'invention est de proposer une solution permettant de mettre en pratique, de manière simple, le principe de déport optique par un faisceau laser composite, des signaux composant les signaux de stimulation, depuis le sous-ensemble chargé de générer ces signaux vers l'ensemble chargé d'amplifier et de rayonner ces signaux.

Un but de l'invention consiste, en particulier, dans le cadre d'une solution de déport optique consistant en un faisceau laser composite dirigé vers un ensemble de capteurs optoélectroniques disposés dans un plan, une matrice de photodiodes par exemple, à trouver une solution permettant de s'affranchir du besoin de mettre en place un moyen de mesure et de correction du biais de phase introduit, pour chacun des signaux formant le signal de stimulation, par la distance et la direction d'incidence du faisceau laser.

A cet effet l'invention a pour objet un dispositif de stimulation radioélectrique d'une antenne comportant au moins un sous ensemble d'émission formé par un réseau d'éléments rayonnants connectés chacun à un récepteur photoélectrique intégré à un réseau de récepteurs photoélectriques ; ainsi qu'un générateur de signaux électriques configuré pour synthétiser, pour chaque élément rayonnant, un signal électrique d'excitation présentant une amplitude et une phase déterminées, fonction de la position de l'élément rayonnant dans le réseau, conformément à une loi d'amplitude-phase donnée et tels que décrits dans les revendications indépendantes et dépendantes.

Les caractéristiques et avantages de l'invention seront mieux appréciés grâce à la description qui suit, description qui s'appuie sur les figures annexées qui présentent :

- les figures 1 et 2, des illustrations schématiques de deux exemples d'architectures de dispositifs de stimulation radioélectrique classiques, faisant partie de l'état de l'art ;
- la figure 3, une illustration schématique du principe de séparation physique des module de génération de forme d'onde et de rayonnement l'un de l'autre ;
- la figure 4, une illustration schématique d'un exemple de mise en oeuvre connu du principe de la figure 3 ;
- la figure 5, une illustration schématique représentant un dispositif de stimulation sur lequel peut être appliqué le principe de l'invention ;
- les figures 6 et 7, des représentations schématiques d'une forme de mise en oeuvre de l'invention mettant en évidence les caractéristiques essentielles de cette dernière ;
- la figure 8, une illustration relative à un premier exemple de réalisation de la forme de mise en oeuvre des figure 6 et 7 ;
- les figures 9 et 10, deux tableaux permettant de définir pour l'exemple de mise en oeuvre de la figure 8, le domaine angulaire de validité de l'invention ;
- les figures 11 et 12, des illustrations relatives à un deuxième et un troisième exemple de réalisation de la forme de mise en oeuvre des figure 6 et 7 ;
- la figure 13, une illustration relative à un quatrième exemple de réalisation de la forme de mise en oeuvre des figure 6 et 7 ;
- la figure 14, une représentation schématique d'une autre forme de mise en oeuvre de l'invention dans laquelle le réseau de photodiodes et le réseau d'éléments rayonnants sont sur deux supports indépendants ;
- la figure 15, une représentation schématique d'une autre forme de mise en oeuvre de l'invention dans laquelle le système comporte deux sous-ensembles d'émission.

Il est à noter que, sur les figures annexées, un même élément fonctionnel ou structurel porte de préférence un même symbole repère.

La figure 5 représente de manière schématique la structure d'un dispositif de stimulation d'une antenne susceptible de pouvoir intégrer l'invention.

Un tel dispositif comporte, de manière classique, un générateur de signaux électriques 51 et un ensemble d'émission 52 dont la fonction est de rayonner les signaux produits par le générateur 51 de façon à former un faisceau radioélectrique dirigé vers l'antenne à tester.

L'ensemble d'émission 52 est constitué de N éléments rayonnants 551 (antennes) formant un réseau 55, généralement plan, alimentés chacun par un module amplificateur de puissance 552.

Le générateur de signaux 51 est configuré pour produire N signaux électriques 511 cohérents les uns des autres et présentant chacun, par rapport à un signal de référence, une phase (déphasage) déterminé par une loi de phase transmise au générateur 51 par ailleurs ou mémorisé dans une mémoire interne.

Chacun des N signaux produits est destiné à alimenter un des N éléments rayonnants 551 (via son module amplificateur 552). La recombinaison dans l'espace des N signaux 511, rayonnés chacun par un élément 53, permettant de former un faisceau dans une direction donnée, fonction de la loi de phase générée par le générateur 51.

La phase de chaque signal électrique 511 produit par le générateur 51 est déterminée en fonction de l'élément rayonnant 551 auquel il est destiné et de la déflexion que l'on veut imposer au faisceau formé par rapport à un axe de référence choisi, l'axe perpendiculaire au plan des éléments rayonnants par exemple.

Le dispositif de stimulation considéré ici comporte cependant, de manière originale, la particularité de transmettre les signaux électriques 511 produits par le générateur de signaux 51 vers l'ensemble d'émission 52 sous la forme d'un faisceau laser composite 53 formé de N ondes lumineuses multiplexées, de longueurs d'ondes différentes, chaque onde lumineuse étant modulé par un des N signaux électriques produits. Pour ce faire, le générateur de signaux 51 comporte N modulateurs électro-optiques 512, un multiplexeur optique 513 ainsi qu'un objectif constituant une optique pointée 514.

Le faisceau laser composite 53 est orienté vers l'ensemble d'émission 52 qui comporte un ensemble de N photodétecteurs 541. Les photodétecteurs 541 sont agencés selon un arrangement formant une structure plane 54, illuminée par le faisceau laser 53 sous une incidence donnée par rapport à la normale *Oy* à cette structure.

Chaque photodétecteur 541 est par ailleurs associé à un filtre de longueurs d'ondes lumineuses 542, configuré de telle façon qu'il ne puisse détecter que l'onde lumineuse modulée par le signal électrique 511 qui lui est destiné.

Selon l'invention, le sous-ensemble d'émission 52 selon l'invention a pour caractéristique avantageuse que l'arrangement des photodétecteurs 541 sur la structure en réseau 54 présente une géométrie identique à l'arrangement des éléments rayonnants 551 sur la structure en réseau 55. Par géométrie identique, on entend ici que la forme de l'alignement des éléments sur chacune des structures 54 et 55 ainsi que les pas d'alignement sont identiques. Cette identité des géométries constitue la caractéristique essentielle de l'invention.

Cette particularité structurelle se traduit par le fait qu'à chaque photodétecteur 541 occupant un position donnée dans l'arrangement du réseau 54 des *N* photodétecteurs, correspond un élément rayonnant 551 occupant une position identique dans l'arrangement du réseau des N éléments rayonnants 551, ces positions étant par exemple définies par des coordonnées identiques dans les repères orthonormés respectivement attachés à chacun des arrangements.

Cette identité de géométrie a pour résultat avantageux que le faisceau radioélectrique formé par l'arrangement d'éléments rayonnants 55 présente sensiblement, par rapport à la normale au plan des éléments rayonnants, une déflexion dont la valeur est égale, moyennant un terme d'erreur, à la direction de déflexion du faisceau radioélectrique déterminée par la loi de phase imposée le générateur 51 à laquelle s'ajoute une direction directement liée à la direction d'incidence du faisceau laser composite sur l'arrangement 54 de photodétecteurs.

La direction du faisceau radioélectrique rayonné se trouve ainsi référencée non plus en absolu par rapport à une direction de référence de l'arrangement des éléments rayonnants, mais en relatif par rapport à la direction d'incidence du faisceau laser composite.

Ce résultat avantageux est plus particulièrement obtenu pour une direction d'incidence du faisceau laser comprise dans un domaine angulaire limité et une direction de déflexion du faisceau radioélectrique comprise également dans un domaine angulaire limité, pour lesquels le terme d'erreur reste acceptable pour l'application considérée. Au-delà de ces domaines le terme d'erreur peut prend une valeur considérée comme non acceptable pour l'application considérée.

La suite de la description présente des exemples de réalisation mettant en oeuvre l'invention dans lesquels les sous-ensembles d'émission comportent des photodétecteurs 541 et des éléments rayonnants 551 agencés selon des arrangements respectifs présentant des géométries identiques.

Les figures 6 et 7 présentent sous forme schématique un premier exemple de structure destinée à constituer un ensemble d'émission 52 selon l'invention. Cette structure est commune aux différents exemples de réalisation décrits dans la suite du texte présentant une telle caractéristique.

Dans cette structure, les photédétecteurs 541, des photodiodes par exemple, et les éléments rayonnants 551 sont agencés sur selon un plan (*xOz*) 61 constitué de cellules élémentaires 62, selon un arrangement orthogonal. Chaque cellule 62 comporte un photodétecteur 541 et un élément rayonnant 551 situés au voisinage l'un de l'autre, les zones actives des deux éléments étant orientées dans une même direction. Les photodétecteurs 541 équipant les cellules 62, des photodiodes par exemple, sont pourvus chacun d'un filtre optique spécifique 542 ne laissant passer que la longueur d'onde $\lambda_{k,l}$ qui lui est dédiée.

Les cellules 62 sont des surfaces pouvant être rectangulaires, mais elles seront plutôt carrées dans le cas général. Elles sont disposées en rangées placées de part et d'autre d'un premier axe de symétrie, l'axe (*Ox*), et en colonnes placées de part et d'autre d'un second axe de symétrie, l'axe (Oz), selon une répartition présentant le point *O* d'intersection des deux axes comme centre de symétrie.

L'agencement des antennes 551 et des photodiodes 541 au niveau des cellules élémentaires 62 est par ailleurs le même pour chaque cellule de sorte que les deux réseaux présentent une même géométrie. Ils sont cependant légèrement décalés selon l'une ou l'autre des directions du plan (*xOz*).

Selon la forme du réseau d'éléments rayonnants (et par suite du réseau de photodiodes), le nombre de cellules dans les rangées et dans les colonnes peut être constant ou varier d'une colonne ou d'une rangée à la colonne ou la rangée voisine.

Ainsi, si les deux réseaux présentent une forme rectangulaire, les cellules sont, par exemple, disposées en $2L$ rangées 63 de part et d'autre d'un premier axe de symétrie, l'axe (*Ox*), et $2K$ colonnes 64 placées de part et d'autre d'un second axe de symétrie, l'axe (*Oz*), selon une répartition présentant le point *O* d'intersection des deux axes comme centre de symétrie.

Autrement dit, la structure comporte, dans ce cas, $4KL$ cellules 62 disposées en *K* colonnes de part et d'autre de l'axe (*Ox*) et en *L* rangées de part et d'autre de l'axe (*Oy*), de telle façon que l'on ait $\overrightarrow{OC}_{-k,-l} = -\overrightarrow{OC}_{k,l}$, $C_{k,l}$ représentant le centre de la cellule située dans la rangée *k* et la colonne *l*. Cet arrangement de cellule présente ainsi une double symétrie axiale par rapport à un axe *Ox* et un axe *Oz*, le point *O* constituant un centre de symétrie.

Alternativement, si les deux réseaux présentent une forme non rectangulaire, une forme circulaire ou elliptique par exemple, les cellules 62 peuvent également être disposées selon un arrangement orthogonal. Toutefois, le nombre de cellules 62 dans une rangée ou une colonne est alors différent selon la position de la rangée ou de la colonne par rapport aux axes de symétrie, une colonne *k* ou une rangées *l* comportant d'autant moins de cellules 62 qu'elle est plus loin d'un axe de symétrie.

Outre des circuits d'alimentation en énergie électrique et de servitude, non représentés dans les figures 6 et 7, l'ensemble d'émission 52 comporte un ensemble d'amplificateurs de puissance identiques 552 en nombre identique au nombre d'éléments rayonnants 551. Chaque amplificateur de puissance reçoit son signal d'entrée d'une photodiode 541 du réseau de photodiodes 54 et délivre un signal amplifié à une antenne du réseau d'antennes radioélectriques 55. Les sorties des photodiodes 541 sont reliées aux entrées des modules amplificateurs 552 dont les sorties sont elles-mêmes reliées sources rayonnantes 551.

De manière préférentielle, pour minimiser les pertes de puissance, les amplificateurs de puissances 5524 sont placés au plus près des antennes radioélectriques 551.

Dans une structure telle que celle illustrée par les figures 6 et 7, les éléments des réseaux d'antennes radioélectriques (éléments rayonnants 551) et de photodétecteurs (photodiodes 541) appartenant aux mêmes cellules 62, le rayonnement du faisceau radioélectrique et l'illumination du réseau de photodiodes par le faisceau laser composite ont lieu selon une même direction de l'espace vis-à-vis du plan 61 des réseaux.

Les photodiodes 541 et les antennes 551 sont repérées de la même façon dans leurs réseaux respectifs, par deux indices *k* selon l'axe *Ox* et *l* selon l'axe *Oz*, qui pour des raisons de symétrie évoluent chacun de façon positive de 1 à une valeur maximale positive spécifique et de façon négative de -1 à une valeur minimale opposée à la valeur maximale positive spécifique.

Ainsi, l'antenne 551 et la photodiode 541 avec son filtre 542 appartenant à une même cellule $C_{k,l}$, d'indices $(k,l)$, sont dénommées respectivement $A_{k,l}$ et $P_{k,l}$.

On notera ici que, si les réseaux 54 et 55 sont rectangulaires pleins, les valeurs minimales et maximales sont respectivement -K et *K* en *x* et *-L* et *L* en z, *K* et *L* étant des entiers positifs. En revanche, si les réseaux sont elliptiques ou circulaires les limites par lignes ou colonnes s'expriment moins simplement car elles dépendent respectivement de la colonne ou de la ligne.

Comme l'illustre la figure 6, une telle structure reçoit donc le faisceau laser composite 53 transmis par le générateur 51 selon une direction incidente donnée 65 et rayonne un faisceau radioélectrique dans une direction d'émission donnée 66.

Soient $\alpha$ et $\beta$ les angles correspondant à la projection de la direction 65 d'arrivée du faisceau laser 53 respectivement sur un plan (*xOy*), dans lequel *Oy* représente la normale au plan 61 passant par le centre de symétrie *O* de la structure, et sur le plan (*xOz*).

Soient également $\alpha'$ et $\beta'$ les angles correspondant à la projection de la direction 66 d'émission du faisceau radioélectrique rayonné par le sous-ensemble d'émission 52, respectivement dans les mêmes plans.

Les valeurs des angles $\alpha'$ et $\beta'$ sont déterminées par la valeur de la loi de phase portée par les différentes ondes lumineuses formant le faisceau laser composite à laquelle s'ajoute les déphasages affectant les ondes reçues par les différentes photodiodes du fait de la direction d'incidence ($\alpha,\beta$) du faisceau laser composite 53.

Conformément à ce qui a été dit précédemment, du fait que, de manière caractéristique, les réseaux qui composent le sous-ensemble d'émission 52 présentent une même géométrie, la direction 66 dans laquelle le faisceau radioélectrique est émis correspond à la direction de déflexion imposée par la loi de phase générée par le générateur 51 à laquelle s'ajoute une direction directement liée à la direction 65 d'arrivée ($\alpha,\beta$) du faisceau laser.

Plus précisément, si les angles $\theta$ et $\psi$ définissent cette direction de déflexion, qui correspondent à la projection de la direction d'émission du faisceau radioélectrique rayonné par le sous-ensemble d'émission 52, respectivement dans les plans (*xOy*) et (*xOz*), on peut écrire :

$$\alpha' \approx \mathrm{a} \cdot \theta + \mathrm{c} \cdot \alpha \qquad [001]$$

et

$$\beta' \approx \mathrm{b} \cdot \psi + \mathrm{d} \cdot \beta \qquad [002]$$

avec *a, b, c et* d valant -1 ou 1.

Selon l'invention, les valeurs, 1 ou -1, des coefficients *a, b, c* et d sont déterminées par les liaisons d'interconnexions réalisées entre les photodiodes 541 et les antennes électromagnétiques 551 pour l'application considérée, chaque photodiode 541 étant reliée à un élément rayonnant 551 par l'intermédiaire d'un élément amplificateur 552. Dans la suite de la description on décrit différentes variantes de câblage pouvant être réalisées dans le cadre de la structure des figures 6 et 7.

La figure 8 illustre un premier exemple de réalisation dans lequel une photodiode 541 $P_{k,l}$ appartenant à une cellule $C_{k,l}$ délivre son signal électrique vers l'élément rayonnant 551 $A_{-k,-l}$ appartenant à la cellule $C_{-k,-l}$ occupant dans la structure une position symétrique de la cellule $C_{k,l}$ par rapport au centre O.

Considérant la structure illustrée par les figures 6 et 7, la formation d'un faisceau radioélectrique dans la direction ($\alpha',\beta'$), 67, par le réseau 55 d'antennes radioélectriques, agencées avec un pas $\delta$ en *x* et en *y*, correspond à la loi de phase suivante:

$$\Delta\varphi'_{-k,-l} = \frac{2\pi\delta}{\lambda}\left[\left(k-\frac{1}{2}\right)\sin\alpha'\cos\beta' + \left(l-\frac{1}{2}\right)\sin\beta'\right] \qquad [003]$$

et

$$\Delta\varphi'_{k,l} = -\frac{2\pi\delta}{\lambda}\left[\left(k-\frac{1}{2}\right)\sin\alpha'\cos\beta' + \left(l-\frac{1}{2}\right)\sin\beta'\right] = -\Delta\varphi'_{-k,-l} \qquad [004]$$

où $\Delta\varphi'_{-k,-l}$ et $\Delta\varphi'_{k,l}$ représentent respectivement les déphasages des signaux radioélectriques rayonnés par l'élément rayonnant situé dans la cellule $C_{-k,-l}$ et par celui situé dans la cellule $C_{k,l}$, $\lambda$ étant la longueur d'onde radioélectrique dans l'air.

La direction d'arrivée ($\alpha$, $\beta$) du faisceau laser composite 53 sur le réseau de photodiodes 54 produit sur le signal électrique porté la loi de phase suivante :

$$\Delta\varphi_{-k,-l} = -\frac{2\pi\delta}{\lambda}\left[\left(k-\frac{1}{2}\right)\sin\alpha\cos\beta + \left(l-\frac{1}{2}\right)\sin\beta\right]$$

et

$$\Delta\varphi_{k,l} = \frac{2\pi\delta}{\lambda}\left[\left(k-\frac{1}{2}\right)\sin\alpha\cos\beta + \left(l-\frac{1}{2}\right)\sin\beta\right] = -\Delta\varphi_{-k,-l}$$

Le faisceau laser composite 53 transmis au réseau de photodiodes 54 porte une loi de phase qui, si elle était appliquée directement et normalement au réseau 55 d'antennes radioélectriques produirait un faisceau radioélectrique

dans la direction ($\theta,\psi$), les angles $\theta$ et $\psi$ étant reliés à la loi de phase précédente par les relations :

$$\Delta\varphi^{p}_{-k,-l} = \frac{2\pi\delta}{\lambda}\left[\left(k-\frac{1}{2}\right)\sin\theta\cos\psi + \left(l-\frac{1}{2}\right)\sin\psi\right] \qquad [005]$$

et

$$\Delta\varphi^{p}_{k,l} = -\frac{2\pi\delta}{\lambda}\left[\left(k-\frac{1}{2}\right)\sin\psi\cos\theta + \left(l-\frac{1}{2}\right)\sin\psi\right] = -\Delta\varphi^{p}_{-k,-l} \qquad [006]$$

Par ailleurs, le branchement de la sortie électrique de chaque photodiode $P_{k,l}$ sur l'entrée de l'amplificateur 552 qui délivre sa puissance à l'antenne radioélectrique $A_{-k,-l}$, engendre un faisceau radioélectrique dont la direction est définie par la loi de phase suivante :

$$\Delta\varphi'_{-k,-l} = \Delta\varphi_{k,l} + \Delta\varphi^{p}_{k,l} \qquad [007]$$

et

$$\Delta\varphi'_{k,l} = \Delta\varphi_{-k,-l} + \Delta\varphi^{p}_{-k,-l} \qquad [008]$$

Par suite, on en déduit directement de ce qui précède l'équation reliant les trois directions ($\alpha',\beta'$), ($\alpha,\beta$) et ($\theta,\psi$) :

$$\frac{2\pi\delta}{\lambda}\left[\left(k-\frac{1}{2}\right)\sin\alpha'\cos\beta' + \left(l-\frac{1}{2}\right)\sin\beta'\right] = \frac{2\pi\delta}{\lambda}\left[\left(k-\frac{1}{2}\right)\sin\alpha\cos\beta + \left(l-\frac{1}{2}\right)\sin\beta\right] - \frac{2\pi\delta}{\lambda}\left[\left(k-\frac{1}{2}\right)\sin\theta\cos\psi + \left(l-\frac{1}{2}\right)\sin\psi\right] \qquad [009]$$

L'indépendance en *k* et en *l* conduit, au vu des équations précédentes, à la solution suivante :

$$\sin\beta' = \sin\beta - \sin\psi \qquad [010]$$

et

$$\sin\alpha'\cos\beta' = \sin\alpha\cos\beta - \sin\theta\cos\psi \qquad [011]$$

Ce qui peut encore s'écrire :

$$\beta' = \mathrm{Arcsin}(\sin\beta - \sin\psi) \qquad [012]$$

et

$$\alpha' = \mathrm{Arcsin}\left(\frac{\sin\alpha\cos\beta - \sin\theta\cos\psi}{\sqrt{1-(\sin\beta-\sin\psi)^2}}\right) \qquad [013]$$

Considérant les relations précédentes, on constate que si la direction donnée par la loi de phase ($\theta,\psi$) portée par le faisceau laser composite est égale ($\theta,\psi$) = (0,0) (distribution équiphase), on obtient ($\alpha',\beta'$) = ($\alpha,\beta$).

On constate alors que le sous-ensemble d'émission 52 présente des propriétés de rétrodirectivité similaires à celles d'un réseau rayonnant de Van Atta, connu par ailleurs, à ceci près que le dispositif selon l'invention n'est pas un dispositif entièrement radioélectrique mais un dispositif hybride optique-radioélectrique.

La direction d'émission 66 du faisceau radioélectrique est alors inconditionnellement égale à la direction d'arrivée 65 du faisceau laser composite 53, les sens de propagation étant inverses l'un de l'autre.
En revanche, si la direction donnée par la loi de phase portée par le faisceau laser composite est $(\theta,\psi) \neq (0,0)$, les relations [012] et [013] ne se simplifient plus comme dans le cas précédent.
Toutefois, il reste possible d'exprimer les angles $\alpha'$ et $\beta'$ définissant la direction du faisceau radioélectrique formé, de la façon suivante :

$$\beta' = (\beta - \psi) + [\text{Arcsin}(\sin\beta - \sin\psi) - (\beta - \psi)] \qquad [014]$$

$$\alpha' = (\alpha - \theta) + \left[\text{Arcsin}\left(\frac{\sin\alpha\cos\beta - \sin\theta\cos\psi}{\sqrt{1-(\sin\beta - \sin\psi)^2}}\right) - (\alpha - \theta)\right] \qquad [015]$$

Par suite, en considérant les deux fonctions $\varepsilon_{\Delta\beta}(\Psi, \text{B})$ et $\varepsilon_{\Delta\alpha}(\Theta, \Psi, \text{A}, \text{B})$ définies par les relations suivantes :

$$\varepsilon_{\Delta\beta}(\Psi, \text{B}) = \text{Arcsin}(\sin \text{B} + \sin\Psi) - (\text{B} + \Psi) \qquad [016]$$

$$\varepsilon_{\Delta\alpha}(\Theta, \Psi, \text{A}, \text{B}) = \text{Arcsin}\left(\frac{\sin \text{A}\cos \text{B} + \sin\Theta\cos\Psi}{\sqrt{1-(\sin \text{B} + \sin\Psi)^2}}\right) - ((\text{A} + \Theta)) \qquad [017]$$

On peut écrire en prenant $\text{A} = \alpha$, $\text{B} = \beta$, $\Theta = \theta$ et $\Psi = -\psi$ :

$$\Delta\beta = \beta' - \beta = -\psi + \varepsilon_{\Delta\beta}(-\psi, \beta) \qquad [018]$$

et

$$\Delta\alpha = \alpha' - \alpha = -\theta + \varepsilon_{\Delta\alpha}(-\theta, -\psi, \alpha, \beta) \qquad [019]$$

On constate ainsi que, dans le cas d'une loi de phase portée par le faisceau laser composite 53 quelconque, correspondant à une direction $(\theta,\psi)$, la direction 66 d'émission du faisceau radioélectrique correspond alors à la direction opposée $(-\theta,-\psi)$, portée par la direction d'arrivée 66 du faisceau laser composite, avec un terme d'erreur près qui peut être calculé à partir des valeurs de $\theta$, $\psi$, $\alpha$ et $\beta$.
Par suite, pour autant que les termes d'erreur $\varepsilon_{\Delta\beta}(-\psi,\beta)$ et $\varepsilon_{\Delta\alpha}(-\theta,-\psi, \alpha, \beta)$ puissent être négligés, on a alors :

$$\beta' \approx -\psi + \beta \qquad \text{et} \qquad \alpha' \approx -\theta + \alpha \qquad [020]$$

La structure d'interconnexion illustrée par la figure 8 permet donc de produire donc un faisceau radioélectrique dans la direction $(\alpha',\beta') \approx (-\theta + \alpha, -\psi + \beta)$ dans le repère de référence $(O',x',y',z')$ du réseau d'éléments rayonnants confondu ici avec le repère de référence $(O,x,y,z)$ du réseau de photodiodes.
L'identité de géométrie des réseaux de photodiodes et d'éléments rayonnants permet ainsi avantageusement de s'affranchir du besoin de calculer pour chaque valeur de la loi de phase le terme de correction à apporter pour obtenir un faisceau radioélectrique dont la direction 66 ne dépende pas de la direction 65 d'incidence du faisceau laser.
Les termes d'erreurs peuvent être déterminés analytiquement à partir des relations [016] et [017] pour des valeurs choisies des angles $\theta$, $\psi$, $\alpha$ et $\beta$. Il est ainsi possible de constituer une table donnant la valeur de ces termes d'erreur, en fonction des valeurs des angles $\theta$, $\psi$, $\alpha$ et $\beta$ et ainsi de déterminer pour une application donnée de déterminer les étendues des domaines angulaires des angles $\theta$, $\psi$, $\alpha$ et $\beta$ pour lesquelles les termes d'erreurs $\varepsilon_{\Delta\beta}(-\psi, \beta)$ et $\varepsilon_{\Delta\alpha}(-\theta, -\psi, \alpha, \beta)$ restent acceptables pour l'application considérée.
La figure 9 présente, pour l'exemple de réalisation de la figure 8, la table des valeurs de $\varepsilon_{\Delta\beta}(-\psi,\beta)$ pour $\psi$ et $\beta$ variant entre +45° et -45°. Cette table permet de déterminer les valeurs angulaires de $\psi$ et $\beta$ définissant un domaine 91 dans lequel $\varepsilon_{\Delta\beta}(-\psi,\beta)$ reste compris entre des valeurs limites données, entre ±3° par exemple.
De manière analogue, la figure 10 présente, pour l'exemple de réalisation de la figure 8, la table des valeurs de $\varepsilon_{\Delta\alpha}(-\theta,-\psi,\alpha,\beta)$ pour $\alpha$ et $\theta$ variant entre +45° et -45°. La table de la figure 10 est donnée pour de $\psi$ = 10° et $\beta$ = 10°.

Elle permet de déterminer les valeurs angulaires de $\alpha$ et $\theta$ définissant un domaine 101 lequel $\varepsilon_{\Delta\alpha}(-\theta,-\psi,\alpha,\beta)$ reste compris entre des valeurs limites données, entre $\pm 3°$ par exemple.

Ainsi, comme l'illustrent les figures 9 et 10, le domaine angulaire dans lequel l'invention montre plus particulièrement son utilité s'appréhende grâce aux deux erreurs $\varepsilon_{\Delta\alpha}$ et $\varepsilon_{\Delta\beta}$, précédemment calculées dans le cas général à deux dimensions.

Il est à noter que l'erreur $\varepsilon_{\Delta\beta}$ étant seulement fonction de deux paramètres, $\psi$ et $\beta$, s'appréhende assez facilement.

En revanche l'erreur $\varepsilon_{\Delta\alpha}$ qui est fonction des quatre paramètres $\theta$, $\psi$, $\alpha$ et $\beta$, s'appréhende moins facilement.

Néanmoins, une étude statistique montre que, par exemple pour les quatre paramètres $\theta$, $\psi$, $\alpha$ et $\beta$, évoluant dans $\pm 15°$, $\varepsilon_{\Delta\alpha}$ varie entre $\pm 5{,}8°$ avec un écart-type de 0,80°, tandis que $\varepsilon_{\Delta\beta}$, varie entre $\pm 1{,}2°$ avec un écart-type de 0,35°. On peut ainsi conclure qu'un intervalle de $\pm 15°$ pour chacun des quatre paramètres $\theta$, $\psi$, $\alpha$ et $\beta$ constitue un domaine angulaire permettant la mise en oeuvre de l'invention, même avec une ouverture du faisceau radioélectrique formé d'environ 6° dans ses deux dimensions.

Il est à noter également que la tabulation de la figure 9 est également valable pour le cas d'un système à une dimension (réseaux constitués de photodiodes ou d'éléments rayonnants alignés selon *Ox* par exemple). On en conclut par exemple que, dans un tel cas :

- pour des domaines de $\alpha$ et $\theta$, ou $\beta$ et $\psi$, de $\pm 25°$, $\varepsilon_{\Delta\alpha}$ ou respectivement $\varepsilon_{\Delta\beta}$ atteint des extrémums de $\pm 7{,}7°$ avec un écart-type de 1,36° ;
- pour des domaines de $\alpha$ et $\theta$, ou $\beta$ et $\psi$, de $\pm 20°$, $\varepsilon_{\Delta\alpha}$ ou respectivement $\varepsilon_{\Delta\beta}$ atteint des extrémums de $\pm 3{,}2°$ avec un écart-type de 0,63°.

L'explication détaillée du principe de l'invention qui a été développé précédemment pour l'exemple d'application de la figure 8, qui présente une configuration d'interconnexion particulière pour laquelle la photodiode $P_{k,l}$ de la cellule $C_{k,l}$ délivre son signal électrique vers l'antenne radioélectrique $A_{-k,-l}$ de la cellule $C_{-k,-l}$ symétrique de $C_{k,l}$ par rapport à *O*, peut être naturellement étendu à d'autres configurations de connexions entre les photodiodes 541 et les éléments rayonnants 551.

Dans la suite du texte on présente de manière non limitative d'autres exemples de réalisation présentant d'autres configurations d'interconnexion. Pour ces autres exemples de mise en oeuvre, on mentionne simplement l'expression des angles $\beta'$ et $\alpha'$ sans reprendre le détail des calculs conduisant à ces résultats, calculs analogues à ceux déjà développés.

La Figure 11 illustre un deuxième exemple de réalisation mettant en oeuvre la structure illustrée par les figures 6 et 7, dans lequel une photodiode 541 $P_{k,l}$ appartenant à une cellule $C_{k,l}$ délivre son signal électrique vers l'élément rayonnant 551 $A_{-k,l}$ appartenant à la cellule $C_{-k,l}$ occupant dans la structure une position symétrique de la cellule $C_{k,l}$ par rapport à l'axe (Oz).

Des calculs analogues à ceux décrits précédemment concernant la structure d'interconnexion illustrée par la figure 8, montrent que la direction d'émission du faisceau radioélectrique se trouve également référencée par rapport à une direction de référence donnée par les angles $\alpha$ et $\beta$. La direction d'émission du faisceau radioélectrique est alors définie par les angles $\beta'$ et $\alpha'$ répondant aux relations:

$$\beta' \approx \psi - \beta \qquad \text{et} \qquad \alpha' \approx -\theta + \alpha \qquad [021]$$

Autrement dit, une telle structure d'interconnexion produit un faisceau radioélectrique dans la direction $(\alpha', \beta') \approx (-\theta + \alpha, \psi - \beta)$ dans le repère de référence (*O',x',y',z'*) du réseau d'éléments rayonnants confondu ici avec le repère de référence (*O,x,y,z*) du réseau de photodiodes.

Par suite on peut écrire, en introduisant les termes $\varepsilon_{\Delta\beta}$ et $\varepsilon_{\Delta\alpha}$ :

$$\Delta\beta = \beta' + \beta = \psi + \varepsilon_{\Delta\beta}(\psi, -\beta) \qquad [022]$$

et

$$\Delta\alpha = \alpha' - \alpha = -\theta + \varepsilon_{\Delta\alpha}(-\theta, \psi, \alpha, -\beta) \qquad [023]$$

les valeurs des termes d'erreurs $\varepsilon_{\Delta\beta}(\psi, -\beta)$ et $\varepsilon_{\Delta\alpha}(-\theta, \psi, \alpha, -\beta)$ étant calculées respectivement par les formules [016] et [017], en prenant A = $\alpha$, B = $-\beta$, $\Theta = -\theta$ et $\Psi = \psi$.

La figure 12 illustre un troisième exemple de réalisation mettant en oeuvre la structure illustrée par les figures 6 et 7, dans lequel une photodiode 541 $P_{k,l}$ appartenant à une cellule $C_{k,l}$ est connectée à l'élément rayonnant 551 $A_{k,-l}$ appartenant à la cellule $C_{k,-l}$ occupant dans la structure une position symétrique de la cellule $C_{k,l}$ par rapport à l'axe (Ox).
Comme pour l'exemple de réalisation précédent, des calculs analogues à ceux décrits précédemment concernant la structure d'interconnexion illustrée par la figure 8, montrent que la direction d'émission du faisceau radioélectrique se trouve également référencée par rapport à une direction de référence donnée par les angles $\alpha$ et $\beta$. La direction d'émission du faisceau radioélectrique est alors définie par les angles $\beta'$ et $\alpha'$ répondant aux relations :

$$\beta' \approx -\psi + \beta \qquad \text{et} \qquad \alpha' \approx \theta - \alpha \qquad [024]$$

Autrement dit, une telle structure d'interconnexion produit un faisceau radioélectrique dans la direction ($\alpha',\beta'$) $\approx$ (0 - $\alpha$, -$\psi$ + $\beta$) dans le repère de référence (*O',x',y',z'*) du réseau d'éléments rayonnants confondu ici avec le repère de référence (*O,x,y,z*) du réseau de photodiodes.
Par suite on peut écrire, en introduisant les termes $\varepsilon_{\Delta\beta}$ et $\varepsilon_{\Delta\alpha}$ :

$$\Delta\beta = \beta' - \beta = -\psi + \varepsilon_{\Delta\beta}(-\psi, \beta) \qquad [025]$$

et

$$\Delta\alpha = \alpha' + \alpha = \theta + \varepsilon_{\Delta\alpha}(\theta, -\psi, -\alpha, \beta) \qquad [026]$$

les valeurs des termes d'erreurs $\varepsilon_{\Delta\beta}(-\psi, \beta)$ et $\varepsilon_{\Delta\alpha}(\theta, -\psi, -\alpha, \beta)$ étant calculées respectivement par les formules [016] et [017], en prenant A = $-\alpha$, B = $\beta$, $\Theta = \theta$ et $\Psi = -\psi$.
La figure 13 illustre un quatrième exemple de réalisation mettant en oeuvre la structure illustrée par les figures 6 et 7, dans lequel une photodiode 541 $P_{k,l}$ appartenant à une cellule $C_{k,l}$ est connectée à l'élément rayonnant 551 $A_{k,l}$ appartenant à la même cellule $C_{k,l}$ (absence de symétrie de connexion).
Comme pour les exemples de réalisation précédents, des calculs analogues à ceux décrits précédemment concernant la structure d'interconnexion illustrée par la figure 8, montrent que la direction d'émission du faisceau radioélectrique se trouve également référencée par rapport à une direction de référence donnée par les angles $\alpha$ et $\beta$. La direction d'émission du faisceau radioélectrique est alors définie par les angles $\beta'$ et $\alpha'$ répondant aux relations :

$$\beta' \approx \psi - \beta \qquad \text{et} \qquad \alpha' \approx \theta - \alpha \qquad [027]$$

Autrement dit, une telle structure d'interconnexion produit un faisceau radioélectrique dans la direction ($\alpha',\beta'$) $\approx$ ($\theta$ - $\alpha$, $\psi$ - $\beta$) dans le repère de référence (*O',x',y',z'*) du réseau d'éléments rayonnants confondu ici avec le repère de référence (*O,x,y,z*) du réseau de photodiodes.
Par suite on peut écrire, en introduisant les termes $\varepsilon_{\Delta\beta}$ et $\varepsilon_{\Delta\alpha}$:

$$\Delta\beta = \beta' + \beta = \psi + \varepsilon_{\Delta\beta}(\psi, -\beta) \qquad [028]$$

et

$$\Delta\alpha = \alpha' + \alpha = \theta + \varepsilon_{\Delta\alpha}(\theta, \psi, -\alpha, -\beta) \qquad [029]$$

les valeurs des termes d'erreurs $\varepsilon_{\Delta\beta}(\psi, -\beta)$ et $\varepsilon_{\Delta\alpha}(\theta, \psi, -\alpha, -\beta)$ étant calculées respectivement par les formules [016] et [017], en prenant A = $-\alpha$, B = $-\beta$, $\Theta = \theta$ et $\Psi = \psi$.
La Figure 14 présente sous forme schématique une deuxième forme de réalisation du sous-ensemble d'émission 52.
Dans cette forme de réalisation les deux réseaux 54 (réseau de photodiodes 541) et 55 (réseau d'éléments rayonnants 551) formant le sous-ensemble d'émission 52 sont portés par deux structures planes distinctes 141 et 142, orientées de façon quelconque l'une par rapport à l'autre. Ils présentent cependant des géométries identiques de sorte que, les deux structures peuvent être décomposées en cellules de formes et de tailles, qui peuvent être repérées de manière identique dans des repères homologues formant chacun un trièdre de sens direct par exemple. De la sorte, une cellule $C_{k,l}$ du réseau 54 renfermant une photodiode $P_{k,l}$ correspond géométriquement à une cellule $C'_{k,l}$ du réseau 55 renfermant une antenne $A_{k,l}$.

Une telle structure ne diffère cependant en rien, d'un point de vue fonctionnel, de la structure décrite précédemment, si ce n'est que la direction d'arrivée du faisceau laser composite 53 sur le réseau 54, défini par les angles $\alpha$ et $\beta$ et la direction d'émission du faisceau radioélectrique rayonné, définie par les angles $\alpha'$ et $\beta'$, se trouve référencées par rapport à des axes de référence séparés. Cependant, dans la mesure où les deux réseaux présentent des géométries identiques, les angles $\alpha'$ et $\beta'$ vérifient toujours les relations établies précédemment, de sorte que l'on conserve les résultats suivants :

$$\alpha' \approx \mathrm{a} \cdot \theta + \mathrm{c} \cdot \alpha \qquad \text{et} \qquad \beta' \approx \mathrm{b} \cdot \psi + \mathrm{d} \cdot \beta$$

avec *a, b, c et* d valant -1 ou 1, les valeurs de *a, b, c et* d étant fonction de la structure d'interconnexion des photodiodes 541 avec les éléments rayonnants 551.

L'architecture de panneau rayonnant décrite dans le texte qui précède, permet ainsi de concevoir et de réaliser des systèmes de test radioélectriques d'antenne constitués de deux entités physiquement séparées : un sous-ensemble 51 générant une loi de phase donnée et un sous-ensemble d'émission 52 rayonnant cette loi de phase, la loi de phase étant transmise du premier au second sous-ensemble, sans support matériel, via un faisceau laser composite.

L'architecture selon l'invention permet ainsi avantageusement de s'affranchir de l'orientation mutuelle des deux sous-ensembles 51 et 52 et, en particulier, du biais sur la loi de phase occasionné par la direction d'arrivée du faisceau laser composite, ledit biais se traduisant sur la direction du signal électromagnétique rayonné par un décalage angulaire de valeur constante égale à l'écart angulaire entre la direction d'arrivée du faisceau laser et l'axe de référence du réseau de photodiodes 54 recevant ce dernier. Un système de correction, à la génération, de la loi de phase transmise au sous-ensemble d'émission 52, pour prendre en compte l'angle d'incidence du faisceau laser, n'est donc avantageusement pas nécessaire.

La figure 15 illustre une variante de structure du système de test selon l'invention. Dans cette variante, le système comporte un sous-ensemble de génération de forme d'onde 51 et plusieurs sous-ensembles rayonnants 52 placés en des endroits distincts, le système de génération de forme d'onde 51 comportant alors une optique pointée pouvant diriger le faisceau laser composite 53 dans différentes directions, chaque sous ensemble d'émission 52 étant illuminé par le faisceau laser 53 séquentiellement.

## Revendications

1. Dispositif de stimulation radioélectrique d'une antenne comportant au moins un sous ensemble d'émission (52) formé par un réseau (55) d'éléments rayonnants (551) alimentés chacun par un signal issu d'un récepteur photoélectrique (541) intégré à un réseau de récepteurs photoélectriques (54) pourvu d'un filtre optique spécifique (542) ne laissant passer que la longueur d'onde qui lui est dédiée ; ainsi qu'un générateur (51) de signaux électriques (511) configuré pour synthétiser, pour chaque élément rayonnant (551), un signal électrique d'excitation (511) présentant une amplitude et une phase déterminées, fonction de la position de l'élément rayonnant dans le réseau (55), conformément à une loi d'amplitude-phase donnée, lesdits signaux électriques (511) étant transmis au sous-ensemble d'émission (52) sous la forme d'un faisceau laser composite (53) configuré pour illuminer le réseau (54) de récepteurs photoélectriques (541) sous une incidence donnée, ledit faisceau étant obtenu par multiplexage de différentes ondes lumineuses (513) modulées chacune par un signal électrique d'excitation (511) ; chacun des récepteurs photoélectriques (541) est configuré pour réaliser la réception d'une onde lumineuse (513) donnée et en ce que le réseau (54) de capteurs photoélectriques (541) et le réseau d'éléments rayonnants (551) présentent sensiblement une même géométrie avec une même symétrie de répartition des éléments constitutifs (541, 551) dans chaque réseau, chaque récepteur photoélectrique (541) délivrant son signal électrique vers un élément rayonnant (551) occupant au sein de son réseau une position identique à celle que ledit récepteur (541) occupe au sein du sien ou une position symétrique de cette dernière, **caractérisé en ce que** le réseau (54) de photodétecteurs (541) et le réseau (55) d'éléments rayonnants (551) du sous-ensemble d'émission (52) sont portés par un même panneau (61) constitué de cellules (62) agencées selon des colonnes *k* et des rangées *l,* chaque cellule (62) comportant un photodétecteur (541) et un élément rayonnant (551) sensiblement colocalisés et dont les surfaces actives sont orientées suivant une même direction parallèle à l'axe (*Oy*) ; le sous-ensemble générateur de signaux (51) étant configuré de telle façon que faisceau laser composite (53) émis illumine le réseau de photodétecteurs selon une direction définie par deux angles $\alpha$ et $\beta$ dans un repère de référence (*Ox, Oy, Oz*), de sorte que la direction selon laquelle le faisceau radioélectrique est rayonné est déterminée par deux angles $\alpha'$ et $\beta'$ définis, dans le repère de référence *(Ox, Oy, Oz),* par les relations :

$$\alpha' \approx \mathrm{a} \cdot \theta + \mathrm{c} \cdot \alpha \qquad \text{et} \qquad \beta' \approx \mathrm{b} \cdot \psi + \mathrm{d} \cdot \beta$$

avec *a, b, c et* d valant -1 ou 1 ;
$\theta$ et $\psi$ étant les angles définissant la déflexion imposée au faisceau radioélectrique par la loi de phase générée par le sous-ensemble générateur de signaux (51).

**2.** Dispositif de stimulation radioélectrique selon la revendication 1, **caractérisé en ce que** le panneau (61) portant le réseau de photodétecteurs (54) et le réseau (55) d'éléments rayonnants présentant deux axes de symétrie se coupant en un centre formant lui-même un centre de symétrie, le réseau de photodétecteurs (54) et le réseau d'éléments rayonnants (55) sont liés électriquement par une structure d'interconnexion permettant d'orienter le signal électrique de sortie de chaque photodétecteur (541) vers un élément rayonnant (551) situé dans une cellule (62) symétrique de la cellule dans laquelle il se trouve par rapport au centre de symétrie ou à l'un des axes de symétrie.

**3.** Dispositif de stimulation radioélectrique selon la revendication 2, **caractérisé en ce que** le panneau (61) portant le réseau de photodétecteurs (54) et le réseau d'éléments rayonnants (55) comportant une pluralité de cellules, agencées en 2*K* colonnes placées de part et d'autre d'un premier axe de symétrie et 2*L* rangées, de part et d'autre d'un second axe de symétrie perpendiculaire au premier axe de symétrie et coupant ce dernier en un point *O* du panneau (61), la sortie du photodétecteur (541) d'une cellule $C_{k,l}$ délivre son signal électrique vers l'élément rayonnant (551) de la cellule $C_{-k',-l}$ symétrique de la cellule $C_{k,l}$ par rapport au centre de symétrie *O*.

**4.** Dispositif de stimulation radioélectrique selon la revendication 2, **caractérisé en ce que** le panneau (61) portant le réseau de photodétecteurs (54) et le réseau d'éléments rayonnants (55) comportant une pluralité de cellules, agencées en 2*K* colonnes placées de part et d'autre d'un premier axe de symétrie et 2*L* rangées, de part et d'autre d'un second axe de symétrie perpendiculaire au premier axe de symétrie et coupant ce dernier en un point *O* du panneau (61), la sortie du photodétecteur (541) d'une cellule $C_{k,l}$ délivre son signal électrique vers l'élément rayonnant (551) de la cellule $C_{k,-l}$ symétrique de la cellule $C_{k,l}$ par rapport au premier axe de symétrie.

**5.** Dispositif de stimulation radioélectrique selon la revendication 2, **caractérisé en ce que** le panneau (61) portant le réseau de photodétecteurs (54) et le réseau d'éléments rayonnants (55) comportant une pluralité de cellules, agencées en 2*K* colonnes placées de part et d'autre d'un premier axe de symétrie et 2*L* rangées, de part et d'autre d'un second axe de symétrie perpendiculaire au premier axe de symétrie et coupant ce dernier en un point *O* du panneau (61), la sortie du photodétecteur (541) d'une cellule $C_{k,l}$ délivre son signal électrique vers l'élément rayonnant (551) de la cellule $C_{-k,l}$ symétrique de la cellule $C_{k,l}$ par rapport au second axe de symétrie.

**6.** Dispositif de stimulation radioélectrique selon la revendication 2, **caractérisé en ce que** le panneau (61) portant le réseau de photodétecteurs (54) et le réseau d'éléments rayonnants (55) comportant une pluralité de cellules, agencées en 2K colonnes placées de part et d'autre d'un premier axe de symétrie et 2*L* rangées, de part et d'autre d'un second axe de symétrie perpendiculaire au premier axe de symétrie et coupant ce dernier en un point *O* du panneau (61), la sortie du photodétecteur (541) d'une cellule $C_{k,l}$ délivre son signal électrique vers l'élément rayonnant (551) appartenant à la même la cellule $C_{k,l}$.

**7.** Dispositif de stimulation radioélectrique d'une antenne comportant au moins un sous ensemble d'émission (52) formé par un réseau (55) d'éléments rayonnants (551) alimentés chacun par un signal issu d'un récepteur photoélectrique (541) intégré à un réseau de récepteurs photoélectriques (54) pourvu d'un filtre optique spécifique (542) ne laissant passer que la longueur d'onde qui lui est dédiée ; ainsi qu'un générateur (51) de signaux électriques (511) configuré pour synthétiser, pour chaque élément rayonnant (551), un signal électrique d'excitation (511) présentant une amplitude et une phase déterminées, fonction de la position de l'élément rayonnant dans le réseau (55), conformément à une loi d'amplitude-phase donnée, lesdits signaux électriques (511) étant transmis au sous-ensemble d'émission (52) sous la forme d'un faisceau laser composite (53) configuré pour illuminer le réseau (54) de récepteurs photoélectriques (541) sous une incidence donnée, ledit faisceau étant obtenu par multiplexage de différentes ondes lumineuses (513) modulées chacune par un signal électrique d'excitation (511) ; chacun des récepteurs photoélectriques (541) est configuré pour réaliser la réception d'une onde lumineuse (513) donnée et en ce que le réseau (54) de capteurs photoélectriques (541) et le réseau d'éléments rayonnants (551) présentent sensiblement une même géométrie avec une même symétrie de répartition des éléments constitutifs (541, 551) dans chaque réseau, chaque récepteur photoélectrique (541) délivrant son signal électrique vers un élément rayonnant (551) occupant au sein de son réseau une position identique à celle que ledit récepteur (541) occupe au sein du sien ou une position symétrique de cette dernière, le dispositif étant **caractérisé en ce que** le réseau (54) de photodétecteurs (541) et le réseau (55) d'éléments rayonnants (551) sont portés par deux panneaux distincts (141, 142) constitués de cellules (143, 144) agencées selon des colonnes *k* et des rangées *l,* chaque cellule (143) d'un premier panneau (141) comportant un photodétecteur (541) et chaque cellule (144) d'un second panneau (142) comportant un élément rayonnant (551); le sous-ensemble générateur de signaux (51) étant configuré de telle façon que faisceau laser composite (56) émis illumine le réseau de photodétecteurs (54) selon une direction définie par deux angles $\alpha$ et $\beta$ dans un repère de référence (*Ox, Oy, Oz*), de sorte que la direction selon laquelle le faisceau radioélectrique est rayonné est déterminée par deux angles $\alpha'$ et $\beta$ définis, dans un repère de référence (*Ox',Oy',Oz'*) homologue du repère *(Ox, Oy, Oz),* par les relations :

$$\alpha' \approx \mathrm{a} \cdot \theta + \mathrm{c} \cdot \alpha \qquad \text{et} \qquad \beta' \approx \mathrm{b} \cdot \psi + \mathrm{d} \cdot \beta$$

avec *a, b, c et* d valant -1 ou 1 ;

$\theta$ et $\psi$ étant les angles définissant la déflexion imposée au faisceau radioélectrique par la loi de phase générée par le sous-ensemble générateur de signaux (51).

**8.** Dispositif de stimulation radioélectrique d'une antenne selon la revendication 1, **caractérisé en ce qu'**il comporte une pluralité de sous-ensembles d'émission (52) et un sous-ensemble générateur de signaux (51), ledit générateur de signaux étant configuré pour produire un faisceau laser composite pouvant être dirigé sur le réseau de photodétecteurs (551) de l'un ou l'autre des sous-ensembles d'émission.

## Patentansprüche

**1.** Vorrichtung zur radioelektrischen Stimulation einer Antenne, aufweisend mindestens ein Sendeteilsystem (52), das durch ein Netz (55) von strahlenden Elementen (551) gebildet ist, die jeweils von einem Signal gespeist werden, das von einem photoelektrischen Empfänger (541) ausgegeben wird, der in einem Netz von photoelektrischen Empfängern (54) integriert ist, das mit einem spezifischen optischen Filter (542) versehen ist, das nur die Wellenlänge passieren lässt, für die es gedacht ist; sowie einen Generator (51) für elektrische Signale (511), der dafür konfiguriert ist, für jedes strahlende Element (551) ein elektrisches Erregersignal (511) zu synthetisieren, das eine bestimmte Amplitude und Phase darstellt, wobei als Funktion der Position des strahlenden Elements in dem Netz (55) gemäß einem gegebenen Amplituden-PhasenGesetz die elektrischen Signale (511) in Form eines zusammengesetzten Laserstrahls (53) an das Sendeteilsystem (52) übertragen werden, der dafür konfiguriert ist, das Netz (54) von photoelektrischen Empfängern (541) mit einer gegebenen Inzidenz zu beleuchten, wobei der Strahl durch Multiplexieren von verschiedenen Lichtwellen (513) erhalten wird, die jeweils durch ein elektrisches Erregersignal (511) moduliert sind;

wobei jeder der photoelektrischen Empfänger (541) dafür konfiguriert ist, den Empfang einer gegebenen Lichtwelle (513) umzusetzen, und dass das Netz (54) von photoelektrischen Sensoren (541) und das Netz von strahlenden Elementen (551) im Wesentlichen eine gleiche Geometrie mit einer gleichen Symmetrie der Verteilung der bildenden Elemente (541, 551) in jedem Netz aufweisen, wobei jeder photoelektrische Empfänger (541) sein elektrisches Signal einem strahlenden Element (551) zuführt, das in seinem Netz eine identische Position zu derjenigen einnimmt, die der Empfänger (541) in seinem einnimmt, oder eine Position, die zu dieser symmetrisch ist,

**dadurch gekennzeichnet, dass**

das Netz (54) von Photoempfängern (541) und das Netz (55) von strahlenden Elementen (551) des Sendeteilsystems (52) von einem gleichen Feld (61) getragen sind, das aus Zellen (62) gebildet ist, die in Spalten *k* und Zeilen / angeordnet sind, wobei jede Zelle (62) einen Photoempfänger (541) und ein strahlendes Element (551) aufweist, die im Wesentlichen kolokalisiert sind und deren aktiven Oberflächen einer gleichen Richtung parallel zur Achse (*Oy*) folgend ausgerichtet sind; wobei das Signalgenerator-Teilsystem (51) derart konfiguriert ist, dass der ausgegebene zusammengesetzte Laserstrahl (53) das Netz von Photoempfängern in einer durch zwei Winkel $\alpha$ und $\beta$ in einem Bezugsrahmen (*Ox, Oy, Oz*) definierten Richtung beleuchtet, so dass die Richtung, in der der radioelektrische Strahl ausgestrahlt wird, durch zwei Winkel $\alpha'$ und $\beta$ bestimmt wird, die in dem Bezugsrahmen (*Ox, Oy, Oz*) durch folgende Beziehungen definiert sind:

$$\alpha' \approx a \cdot \theta + c \cdot \alpha \text{ und } \beta' \approx b \cdot \psi + d \cdot \beta$$

wobei *a, b, c* und *d* den Wert -1 oder 1 haben;
wobei $\theta$ und $\psi$ die Winkel sind, die die Ablenkung definieren, die dem radioelektrischen Strahl durch das Phasengesetz aufgeprägt ist, das durch das Signalgenerator-Teilsystem (51) erzeugt wird.

**2.** Vorrichtung zur radioelektrischen Stimulation nach Anspruch 1, **dadurch gekennzeichnet, dass**, wenn das Feld (61) das Netz von Photoempfängern (54) trägt und das Netz (55) von strahlenden Elementen zwei Symmetrieachsen aufweist, die sich in einem Zentrum schneiden, welches selbst ein Symmetriezentrum bildet, das Netz von Photoempfängern (54) und das Netz von strahlenden Elementen (55) elektrisch durch eine Zusammenschaltungsstruktur verknüpft sind, die es ermöglicht, das elektrische Ausgangssignal eines jeden Photoempfängers (541) zu einem strahlenden Element (551) hin auszurichten, das sich in einer Zelle (62) befindet, die zu der Zelle symmetrisch ist, in der es sich in Bezug auf das Symmetriezentrum oder eine der Symmetrieachsen befindet.

**3.** Vorrichtung zur radioelektrischen Stimulation nach Anspruch 2, **dadurch gekennzeichnet, dass**, wenn das Feld (61) das Netz von Photoempfängern (54) trägt und das Netz von strahlenden Elementen (55) eine Vielzahl von Zellen aufweist, die in *2K* Spalten, die auf jeder Seite einer ersten Symmetrieachse platziert sind, und *2L* Zeilen auf jeder Seite einer zweiten Symmetrieachse senkrecht zu der ersten Symmetrieachse und Letztere in einem Punkt O des Felds (61) schneidend, angeordnet sind, der Ausgang des Photoempfängers (541) einer Zelle $C_{k,l}$ sein elektrisches Signal dem strahlenden Element (551) der Zelle $C_{-k,-l}$ symmetrisch zu der Zelle $C_{k,l}$ in Bezug auf das Symmetriezentrum O zuführt.

**4.** Vorrichtung zur radioelektrischen Stimulation nach Anspruch 2, **dadurch gekennzeichnet, dass**, wenn das Feld (61) das Netz von Photoempfängern (54) trägt und das Netz von strahlenden Elementen (55) eine Vielzahl von Zellen aufweist, die in *2K* Spalten, die auf jeder Seite einer ersten Symmetrieachse platziert sind, und *2L* Zeilen auf jeder Seite einer zweiten Symmetrieachse senkrecht zu der ersten Symmetrieachse und Letztere in einem Punkt O des Felds (61) schneidend, angeordnet sind, der Ausgang des Photoempfängers (541) einer Zelle $C_{k,l}$ sein elektrisches Signal dem strahlenden Element (551) der Zelle $C\text{-}_{k,-l}$ symmetrisch zu der Zelle $C_{k,l}$ in Bezug auf die erste Symmetrieachse zuführt.

**5.** Vorrichtung zur radioelektrischen Stimulation nach Anspruch 2, **dadurch gekennzeichnet, dass**, wenn das Feld (61) das Netz von Photoempfängern (54) trägt und das Netz von strahlenden Elementen (55) eine Vielzahl von Zellen aufweist, die in *2K* Spalten, die auf jeder Seite einer ersten Symmetrieachse platziert sind, und *2L* Zeilen auf jeder Seite einer zweiten Symmetrieachse senkrecht zu der ersten Symmetrieachse und Letztere in einem Punkt O des Felds (61) schneidend, angeordnet sind, der Ausgang des Photoempfängers (541) einer Zelle $C_{k,l}$ sein elektrisches Signal dem strahlenden Element (551) der Zelle $C_{-k,-l}$ symmetrisch zu der Zelle $C_{k,l}$ in Bezug auf die zweite Symmetrieachse zuführt.

**6.** Vorrichtung zur radioelektrischen Stimulation nach Anspruch 2, **dadurch gekennzeichnet, dass**, wenn das Feld (61) das Netz von Photoempfängern (54) trägt und das Netz von strahlenden Elementen (55) eine Vielzahl von Zellen aufweist, die in *2K* Spalten, die auf jeder Seite einer ersten Symmetrieachse platziert sind, und *2L* Zeilen auf jeder Seite einer zweiten Symmetrieachse senkrecht zu der ersten Symmetrieachse und Letztere in einem Punkt O des Felds (61) schneidend, angeordnet sind, der Ausgang des Photoempfängers (541) einer Zelle $C_{k,l}$ sein elektrisches Signal dem strahlenden Element (551) zuführt, das zur gleichen Zelle $C_{k,l}$ gehört.

**7.** Vorrichtung zur radioelektrischen Stimulation einer Antenne, aufweisend mindestens ein Sendeteilsystem (52), das durch ein Netz (55) von strahlenden Elementen (551) gebildet ist, die jeweils von einem Signal gespeist werden, das von einem photoelektrischen Empfänger (541) ausgegeben wird, der in einem Netz von photoelektrischen Empfängern (54) integriert ist, das mit einem spezifischen optischen Filter (542) versehen ist, das nur die Wellenlänge passieren lässt, für die es gedacht ist; sowie einen Generator (51) für elektrische Signale (511), der dafür konfiguriert ist, für jedes strahlende Element (551) ein elektrisches Erregersignal (511) zu synthetisieren, das eine bestimmte Amplitude und Phase darstellt, wobei als Funktion der Position des strahlenden Elements in dem Netz (55) gemäß einem gegebenen Amplituden-PhasenGesetz die elektrischen Signale (511) in Form eines zusammengesetzten Laserstrahls (53) an das Sendeteilsystem (52) übertragen werden, der dafür konfiguriert ist, das Netz (54) von photoelektrischen Empfängern (541) mit einer gegebenen Inzidenz zu beleuchten, wobei der Strahl durch Multiplexieren von verschiedenen Lichtwellen (513) erhalten wird, die jeweils durch ein elektrisches Erregersignal (511) moduliert sind;

wobei jeder der photoelektrischen Empfänger (541) dafür konfiguriert ist, den Empfang einer gegebenen Lichtwelle (513) umzusetzen und dass das Netz (54) von photoelektrischen Sensoren (541) und das Netz von strahlenden Elementen (551) im Wesentlichen eine gleiche Geometrie mit einer gleichen Symmetrie der Verteilung der bildenden Elemente (541, 551) in jedem Netz aufweisen,
wobei jeder photoelektrische Empfänger (541) sein elektrisches Signal einem strahlenden Element (551) zuführt, das in seinem Netz eine identische Position zu derjenigen einnimmt, die der Empfänger (541) in seinem einnimmt, oder eine Position, die zu dieser symmetrisch ist,
wobei die Vorrichtung **dadurch gekennzeichnet ist, dass** das Netz (54) von Photoempfängern (541) und das Netz (55) von strahlenden Elementen (551) von zwei unterschiedlichen Feldern (141, 142) getragen sind, die aus Zellen (143, 144) gebildet sind, die in Spalten *k* und Zeilen / angeordnet sind, wobei jede Zelle (143) eines ersten Felds (141) einen Photoempfänger (541) aufweist und jede Zelle (144) eines zweiten Felds (142) ein strahlendes Element (551) aufweist; wobei das Signalgenerator-Teilsystem (51) derart konfiguriert ist, dass der ausgegebene zusammengesetzte Laserstrahl (56) das Netz von Photoempfängern (54) in einer durch zwei Winkel $\alpha$ und $\beta$ in einem Bezugsrahmen (*Ox*, *Oy, Oz*) definierten Richtung beleuchtet, so dass die Richtung, in der der radioelektrische Strahl ausgestrahlt wird, durch zwei Winkel $\alpha'$ und $\beta'$ bestimmt wird, die in einem Bezugsrahmen (*Ox', Oy', Oz'*) homolog zu dem Rahmen *(Ox, Oy, Oz)* durch folgende Beziehungen definiert sind:

$$\alpha' \approx \mathrm{a} \cdot \theta + \mathrm{c} \cdot \alpha \ \text{ und } \beta' \approx \mathrm{b} \cdot \psi + \mathrm{d} \cdot \beta,$$

wobei *a, b,* c und *d* den Wert -1 oder 1 haben;
wobei $\theta$ und $\psi$ die Winkel sind, die die Ablenkung definieren, die dem radioelektrischen Strahl durch das Phasengesetz aufgeprägt ist, das durch das Signalgenerator-Teilsystem (51) erzeugt wird.

**8.** Vorrichtung zur radioelektrischen Stimulation einer Antenne nach Anspruch 1, **dadurch gekennzeichnet, dass** sie eine Vielzahl von Sendeteilsystemen (52) und ein Signalgenerator-Teilsystem (51) aufweist, wobei der Signalgenerator dafür konfiguriert ist, einen zusammengesetzten Laserstrahl zu erzeugen, der von dem einen oder dem anderen der Sendeteilsysteme auf das Netz von Photoempfängern (551) gelenkt werden kann.

## Claims

**1.** A device for the radio stimulation of an antenna having at least one transmission sub-assembly (52) formed by an array (55) of radiating elements (551), each supplied with a signal from a photoelectric receiver (541) integrated into an array of photoelectric receivers (54) provided with a specific optical filter (542), which only allows the passage of the wavelength that is dedicated thereto; as well as an electrical signal (511) generator (51) configured to synthesise, for each radiating element (551), an electrical excitation signal (511) having a set amplitude and phase, as a function of the position of the radiating element in the array (55), in accordance with a given amplitude-phase law, said electrical signals (511) being transmitted to the transmission sub-assembly (52) in the form of a composite laser beam (53) configured to illuminate the array (54) of photoelectric receivers (541) at a given incidence, said beam being obtained by multiplexing various light waves (513) each modulated by an electrical excitation signal (511);

each of the photoelectric receivers (541) being configured to receive a given light wave (513), and in that the array (54) of photoelectric sensors (541) and the array of radiating elements (551) have substantially one and the same geometry with one and the same symmetry of distribution of the constituent elements (541, 551) in each array, each photoelectric receiver (541) delivering its electrical signal to a radiating element (551) occupying, within its array, a position identical to the one that said receiver (541) occupies within its own or a position symmetrical thereto,
**characterised in that**
the array (54) of photodetectors (541) and the array (55) of radiating elements (551) of the transmission sub-assembly (52) are borne by one and the same panel (61) formed of cells (62) arranged in columns *k* and rows *l*, each cell (62) having a photodetector (541) and a radiating element (551) that are substantially collocated and whose active surfaces are oriented in one and the same direction parallel to the axis (*Oy*); the signal generator sub-assembly (51) being configured such that the transmitted composite laser beam (53) illuminates the array of photodetectors in a direction defined by two angles $\alpha$ and $\beta$ in a reference frame *(Ox, Oy, Oz),* such that the direction in which the radio beam is radiated is determined by two angles $\alpha'$ and $\beta'$ defined, in the reference frame *(Ox, Oy, Oz),* by the relationships:

$$\alpha' \approx a \cdot \theta + c \cdot \alpha \quad \text{and} \quad \beta' \approx b \cdot \psi + d \cdot \beta$$

where *a, b, c* and *d* have the value -1 or 1;
$\theta$ and $\psi$ being the angles defining the deflection imposed on the radio beam by the phase law generated by the signal generator sub-assembly (51).

**2.** The radio stimulation device according to claim 1, **characterised in that**, with the panel (61) bearing the array of photodetectors (54) and the array (55) of radiating elements having two axes of symmetry intersecting at a centre, which itself forms a centre of symmetry, the array of photodetectors (54) and the array of radiating elements (55) are electrically linked by an interconnection structure for orienting the electrical output signal of each photodetector (541) toward a radiating element (551) situated in a cell (62) symmetrical to the cell in which it is located, with respect to the centre of symmetry or to one of the axes of symmetry.

**3.** The radio stimulation device according to claim 2, **characterised in that**, with the panel (61) bearing the array of photodetectors (54) and the array of radiating elements (55) containing a plurality of cells, arranged in 2K columns placed on either side of a first axis of symmetry and *2L* rows, on either side of a second axis of symmetry perpendicular to the first axis of symmetry and intersecting the latter at a point O of the panel (61), the output of the photodetector (541) of a cell $C_{k,l}$ delivers its electrical signal to the radiating element (551) of the cell $C_{-k,-l}$, symmetrical to the cell $C_{k,l}$ about the centre of symmetry O.

**4.** The radio stimulation device according to claim 2, **characterised in that**, with the panel (61) bearing the array of photodetectors (54) and the array of radiating elements (55) containing a plurality of cells, arranged in 2K columns placed on either side of a first axis of symmetry and *2L* rows, on either side of a second axis of symmetry perpendicular to the first axis of symmetry and intersecting the latter at a point O of the panel (61), the output of the photodetector (541) of a cell $C_{k,l}$ delivers its electrical signal to the radiating element (551) of the cell $C_{-k,-l}$, symmetrical to the cell $C_{k,l}$ about the first axis of symmetry.

**5.** The radio stimulation device according to claim 2, **characterised in that**, with the panel (61) bearing the array of photodetectors (54) and the array of radiating elements (55) containing a plurality of cells, arranged in 2K columns placed on either side of a first axis of symmetry and *2L* rows, on either side of a second axis of symmetry perpendicular to the first axis of symmetry and intersecting the latter at a point O of the panel (61), the output of the photodetector (541) of a cell $C_{k,l}$ delivers its electrical signal to the radiating element (551) of the cell $C\text{-}_{k,-l}$ symmetrical to the cell $C_{k,l}$ about the second axis of symmetry.

**6.** The radio stimulation device according to claim 2, **characterised in that**, with the panel (61) bearing the array of photodetectors (54) and the array of radiating elements (55) containing a plurality of cells, arranged in 2*K* columns placed on either side of a first axis of symmetry and *2L* rows, on either side of a second axis of symmetry perpendicular to the first axis of symmetry and intersecting the latter at a point O of the panel (61), the output of the photodetector (541) of a cell $C_{k,l}$ delivers its electrical signal to the radiating element (551) belonging to the same cell $C_{k,l}$.

**7.** A device for the radio stimulation of an antenna having at least one transmission sub-assembly (52) formed by an array (55) of radiating elements (551), each supplied with a signal from a photoelectric receiver (541) integrated into an array of photoelectric receivers (54) provided with a specific optical filter (542), which only allows the passage of the wavelength that is dedicated thereto; as well as an electrical signal (511) generator (51) configured to synthesise, for each radiating element (551), an electrical excitation signal (511) having a set amplitude and phase, as a function of the position of the radiating element in the array (55), in accordance with a given amplitude-phase law, said electrical signals (511) being transmitted to the transmission sub-assembly (52) in the form of a composite laser beam (53) configured to illuminate the array (54) of photoelectric receivers (541) at a given incidence, said beam being obtained by multiplexing various light waves (513) each modulated by an electrical excitation signal (511);

each of the photoelectric receivers (541) being configured to receive a given light wave (513), and in that the array (54) of photoelectric sensors (541) and the array of radiating elements (551) have substantially one and the same geometry, with one and the same symmetry of distribution of the constituent elements (541, 551) in each array,
each photoelectric receiver (541) delivering its electrical signal to a radiating element (551) occupying, within its array, a position identical to the one that said receiver (541) occupies within its own or a position symmetrical thereto,

the device being **characterised in that** the array (54) of photodetectors (541) and the array (55) of radiating elements (551) are borne by two distinct panels (141, 142) formed of cells (143, 144) arranged in columns *k* and rows *l*, each cell (143) of a first panel (141) having a photodetector (541) and each cell (144) of a second panel (142) having a radiating element (551); the signal generator sub-assembly (51) being configured such that the transmitted composite laser beam (56) illuminates the array of photodetectors (54) in a direction defined by two angles $\alpha$ and $\beta$ in a reference frame (*Ox*, *Oy, Oz*), such that the direction in which the radio beam is radiated is determined by two angles $\alpha'$ and $\beta$ defined, in a reference frame (*Ox', Oy', Oz'*), homologous to the reference frame (*Ox, Oy, Oz*), by the relationships:

$$\alpha' \approx \mathrm{a} \cdot \theta + \mathrm{c} \cdot \alpha \quad \text{and} \quad \beta' \approx \mathrm{b} \cdot \psi + \mathrm{d} \cdot \beta$$

where *a, b,* c and *d* have the value -1 or 1;

$\theta$ and $\psi$ being the angles defining the deflection imposed on the radio beam by the phase law generated by the signal generator sub-assembly (51).

**8.** The device for the radio stimulation of an antenna according to claim 1, **characterised in that** it contains a plurality of transmission sub-assemblies (52) and a signal generator sub-assembly (51), said signal generator being configured to produce a composite laser beam able to be directed onto the array of photodetectors (551) of one or the other of the transmission sub-assemblies.

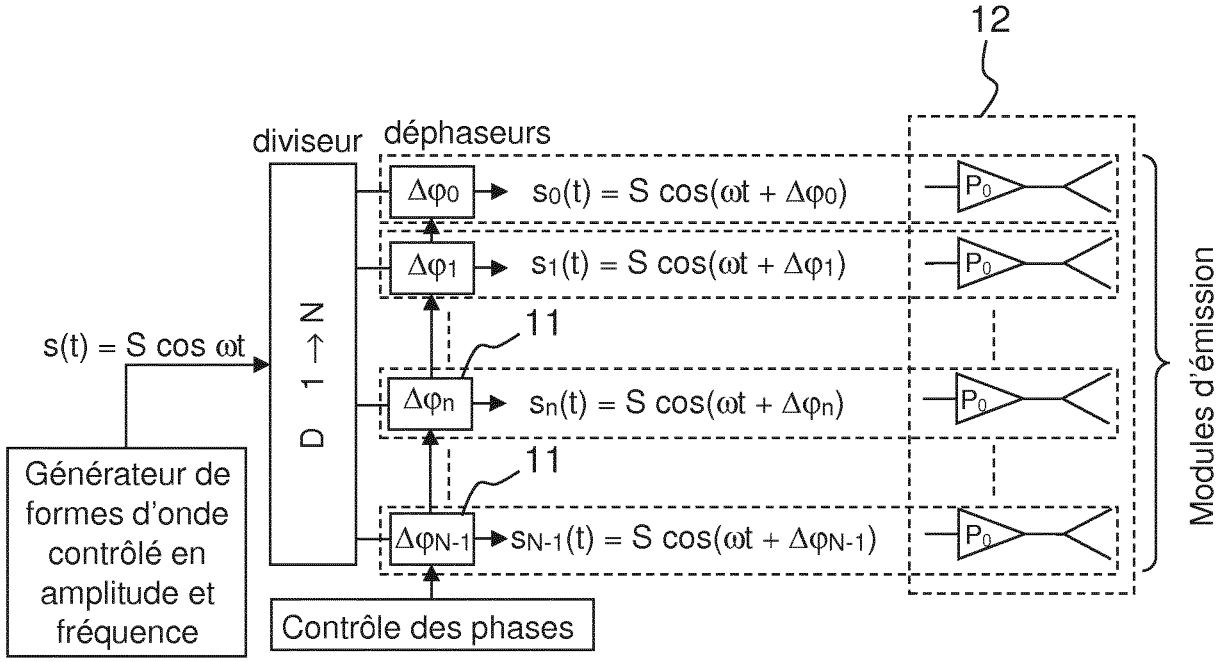
12
diviseur
déphaseurs
Δφ0
s0(t) = S cos(ωt + Δφ0)
Δφ1
s1(t) = S cos(ωt + Δφ1)
Δφn
sn(t) = S cos(ωt + Δφn)
ΔφN-1
sN-1(t) = S cos(ωt + ΔφN-1)
11
11
D 1→N
s(t) = S cos ωt
Générateur de formes d'onde contrôlé en amplitude et fréquence
Contrôle des phases
P0
Modules d'émission

FIG.1

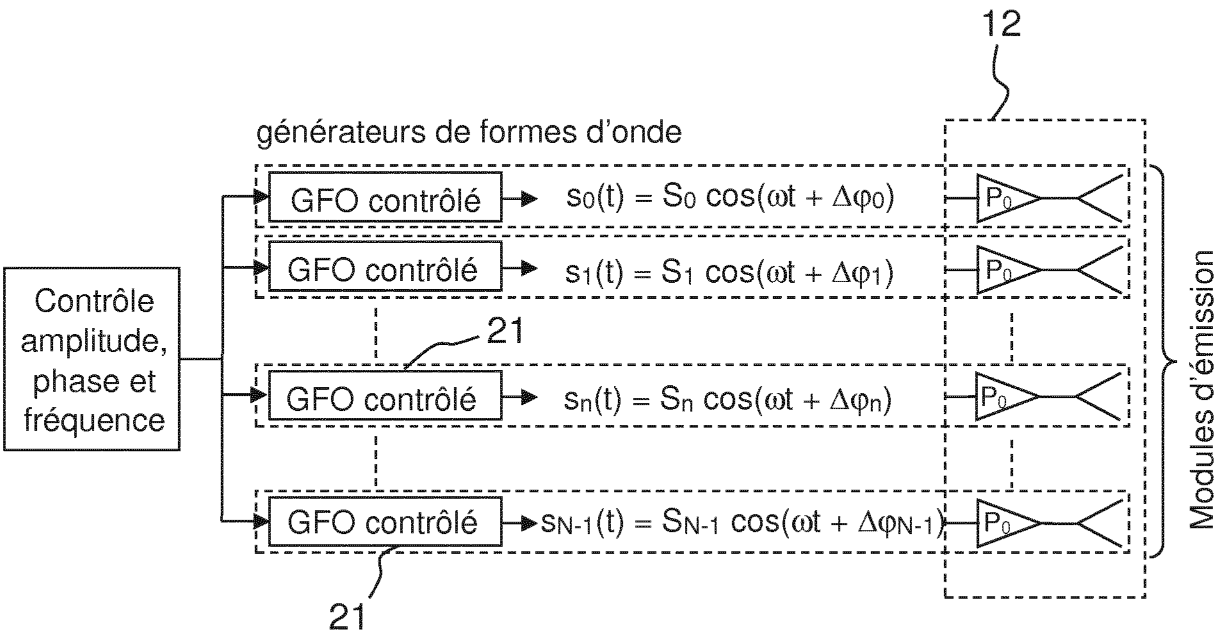
12
générateurs de formes d'onde
GFO contrôlé
s0(t) = S0 cos(ωt + Δφ0)
s1(t) = S1 cos(ωt + Δφ1)
sn(t) = Sn cos(ωt + Δφn)
sN-1(t) = SN-1 cos(ωt + ΔφN-1)
21
21
Contrôle amplitude, phase et fréquence
P0
Modules d'émission

FIG.2

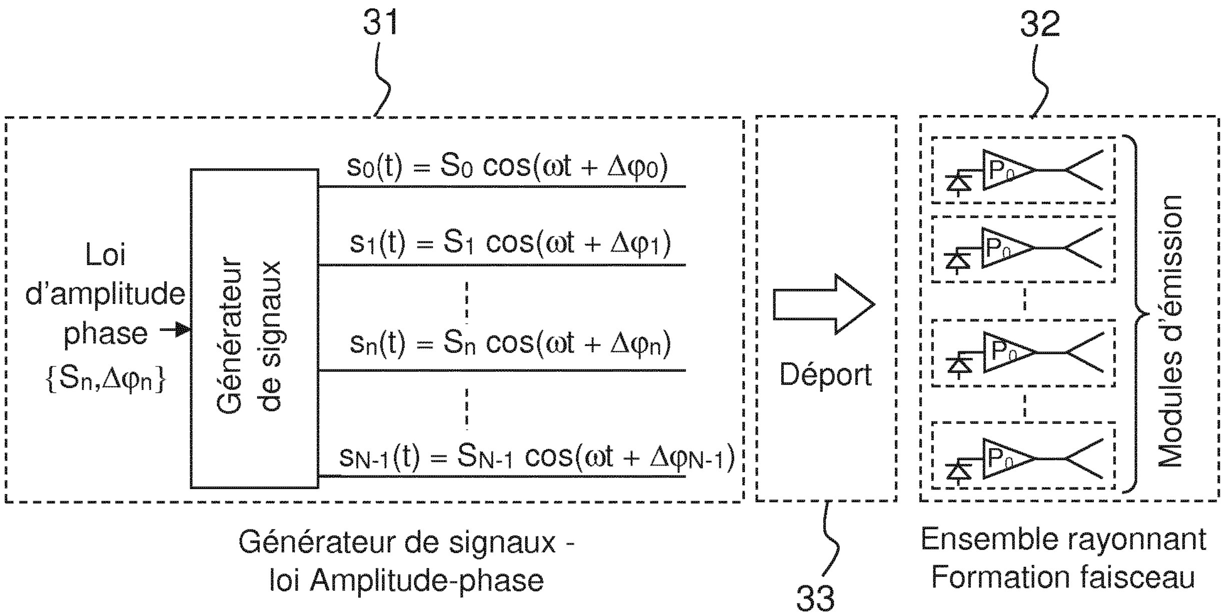
31
32
Loi d'amplitude phase {Sn,Δφn}
Générateur de signaux
s0(t) = S0 cos(ωt + Δφ0)
s1(t) = S1 cos(ωt + Δφ1)
sn(t) = Sn cos(ωt + Δφn)
sN-1(t) = SN-1 cos(ωt + ΔφN-1)
Déport
P0
Modules d'émission
Générateur de signaux - loi Amplitude-phase
33
Ensemble rayonnant Formation faisceau

FIG.3

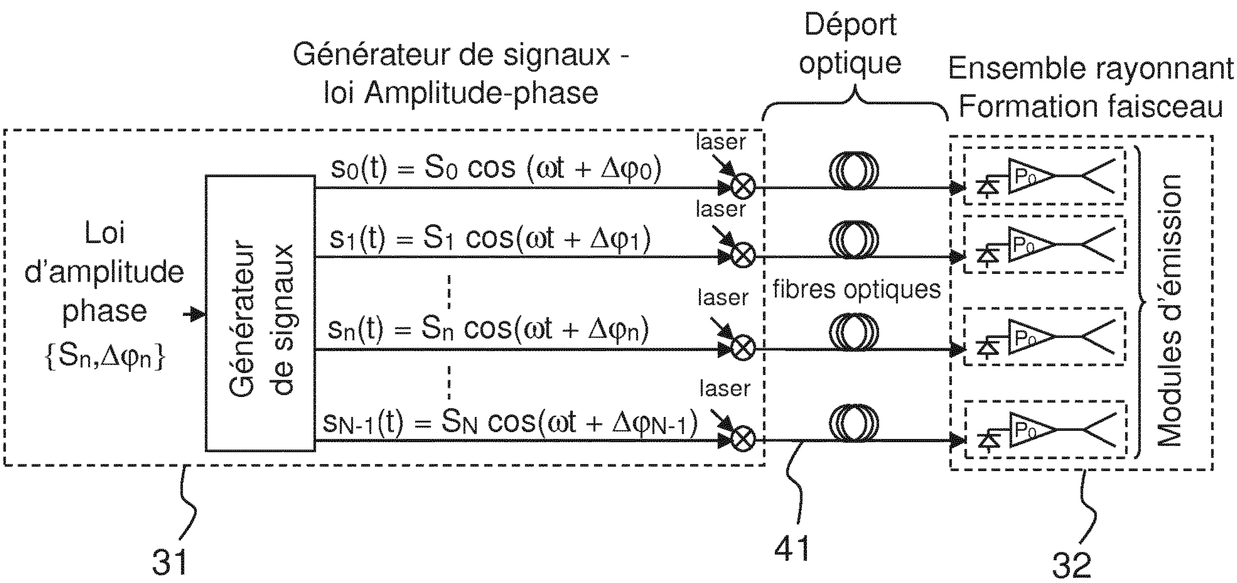
Générateur de signaux - loi Amplitude-phase
Déport optique
Ensemble rayonnant Formation faisceau
Loi d'amplitude phase {Sn,Δφn}
Générateur de signaux
s0(t) = S0 cos (ωt + Δφ0)
s1(t) = S1 cos(ωt + Δφ1)
sn(t) = Sn cos(ωt + Δφn)
sN-1(t) = SN cos(ωt + ΔφN-1)
laser
laser
laser
laser
fibres optiques
P0
Modules d'émission
31
41
32

FIG.4

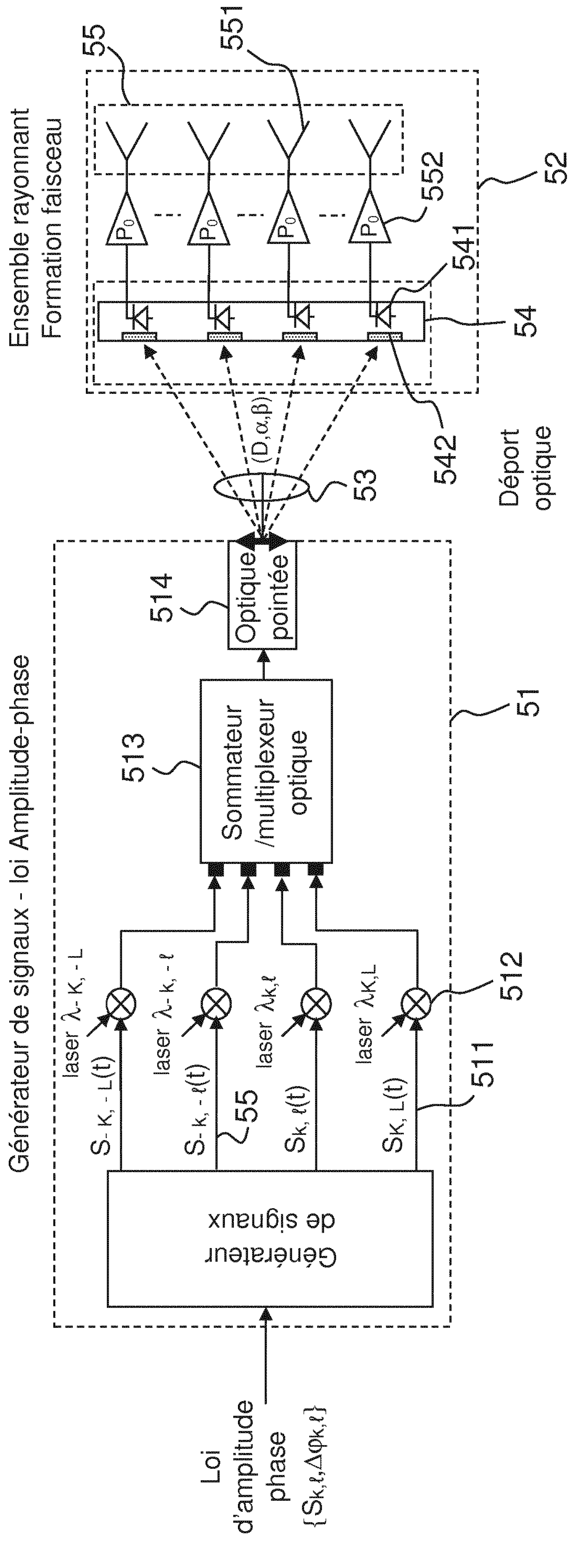
Ensemble rayonnant
Formation faisceau
55
551
552
541
54
52
542
Déport
optique
53
(D,α,β)
Générateur de signaux - loi Amplitude-phase
514
Optique
pointée
513
Sommateur
/multiplexeur
optique
51
laser λ-K, -L
laser λ-k, -ℓ
laser λk,ℓ
laser λK,L
512
511
S-K, -L(t)
S-k, -ℓ(t)
Sk, ℓ(t)
SK, L(t)
55
Générateur
de signaux
Loi
d'amplitude
phase
{Sk,ℓ,Δφk,ℓ}

FIG.5

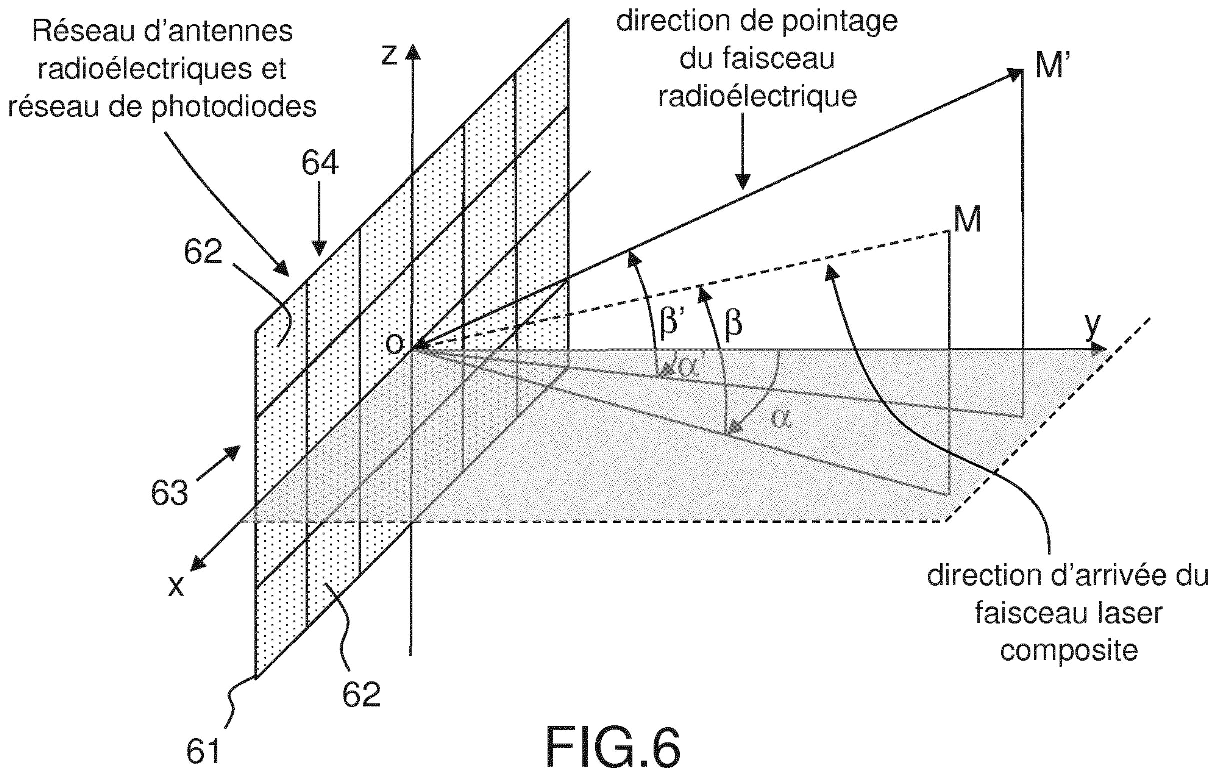
Réseau d'antennes
radioélectriques et
réseau de photodiodes
direction de pointage
du faisceau
radioélectrique
z
M'
M
64
62
o
β'
β
α'
α
y
63
x
62
61
direction d'arrivée du
faisceau laser
composite

FIG.6

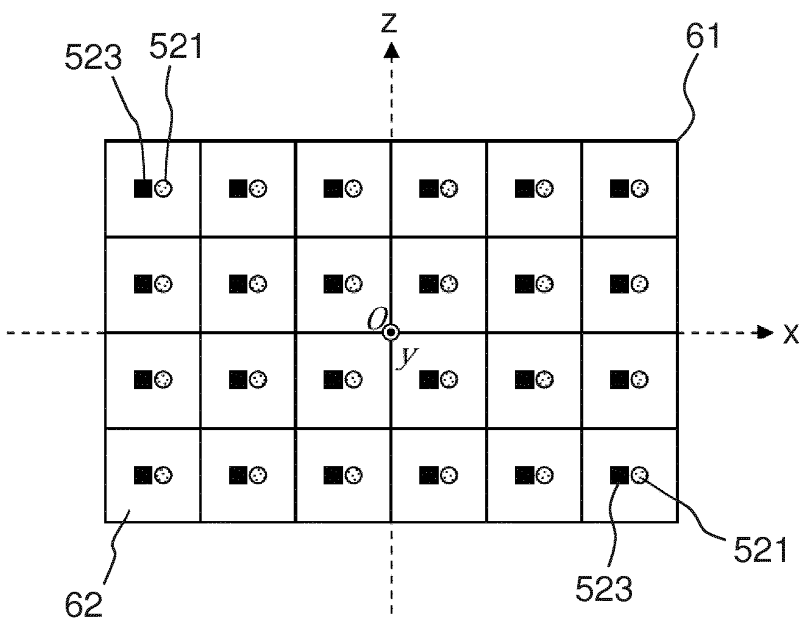
523
521
z
61
O
y
x
62
523
521

FIG.7

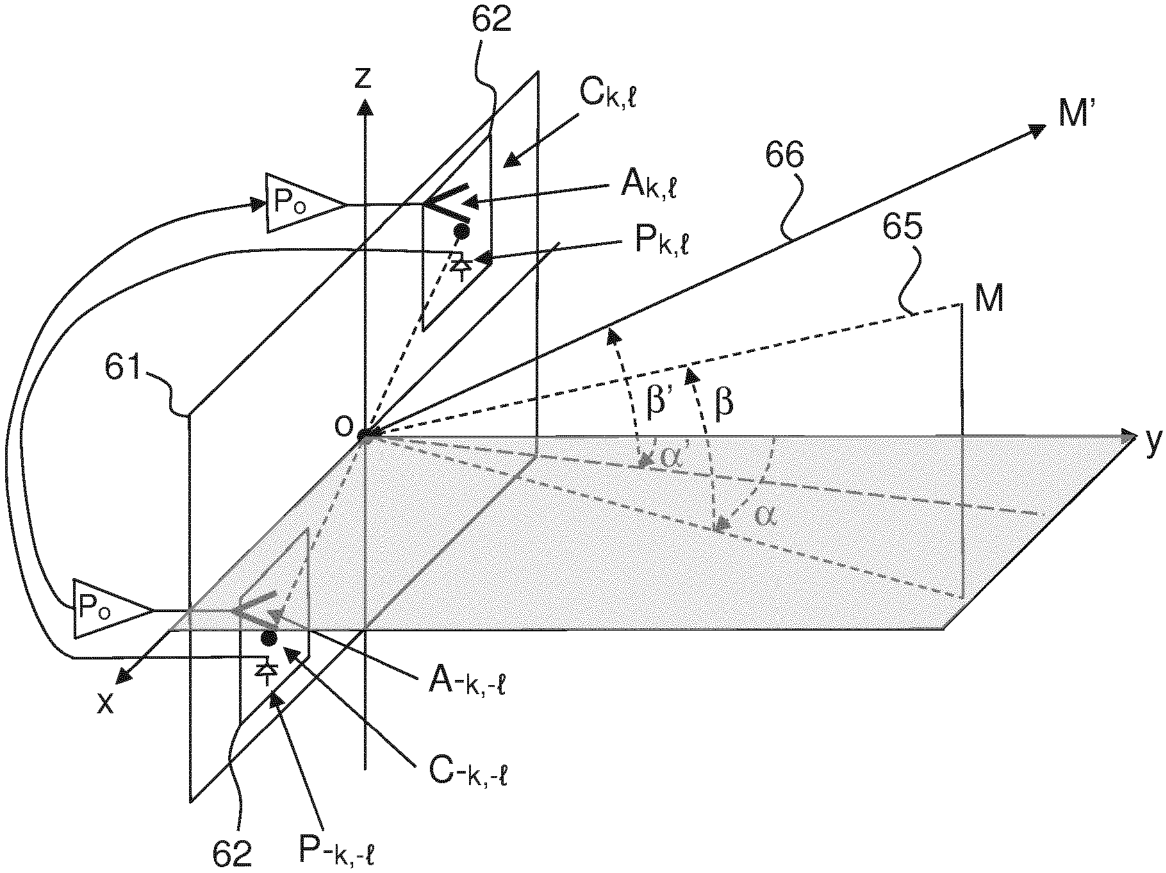


FIG.8

Min = -3 | Max = 3

$\varepsilon\,\Delta\beta = \mathrm{Arcsin}(\sin\psi+\sin\beta)-(\psi+\beta)$

| ψ [deg] | | | | | | | | | | | | | | | | | | | |
|---|---|---|---|---|---|---|---|---|---|---|---|---|---|---|---|---|---|---|---|
| 45 | 0,0 | -1,3 | -2,3 | -3,0 | -3,5 | -3,6 | -3,4 | -2,8 | -1,7 | 0,0 | 2,6 | 6,7 | 15,0 | #### | #### | #### | #### | #### | #### |
| 40 | 1,3 | 0,0 | -1,0 | -1,8 | -2,3 | -2,5 | -2,4 | -2,0 | -1,2 | 0,0 | 1,9 | 4,7 | 9,4 | 20,0 | #### | #### | #### | #### | #### |
| 35 | 2,3 | 1,0 | 0,0 | -0,8 | -1,3 | -1,6 | -1,7 | -1,4 | -0,9 | 0,0 | 1,4 | 3,4 | 6,3 | 11,3 | 25,0 | #### | #### | #### | #### |
| 30 | 3,0 | 1,8 | 0,8 | 0,0 | -0,6 | -0,9 | -1,0 | -1,0 | -0,6 | 0,0 | 1,0 | 2,3 | 4,4 | 7,4 | 12,3 | 30,0 | #### | #### | #### |
| 25 | 3,5 | 2,3 | 1,3 | 0,6 | 0,0 | -0,4 | -0,6 | -0,6 | -0,4 | 0,0 | 0,6 | 1,6 | 3,0 | 4,9 | 7,7 | 12,3 | 25,0 | #### | #### |
| 20 | 3,6 | 2,5 | 1,6 | 0,9 | 0,4 | 0,0 | -0,2 | -0,3 | -0,2 | 0,0 | 0,4 | 1,0 | 1,9 | 3,2 | 4,9 | 7,4 | 11,3 | 20,0 | #### |
| 15 | 3,4 | 2,4 | 1,7 | 1,0 | 0,6 | 0,2 | 0,0 | -0,1 | -0,1 | 0,0 | 0,2 | 0,6 | 1,2 | 1,9 | 3,0 | 4,4 | 6,3 | 9,4 | 15,0 |
| 10 | 2,8 | 2,0 | 1,4 | 1,0 | 0,6 | 0,3 | 0,1 | 0,0 | 0,0 | 0,0 | 0,1 | 0,3 | 0,6 | 1,0 | 1,6 | 2,3 | 3,4 | 4,7 | 6,7 |
| 5 | 1,7 | 1,2 | 0,9 | 0,6 | 0,4 | 0,2 | 0,1 | 0,0 | 0,0 | 0,0 | 0,0 | 0,1 | 0,2 | 0,4 | 0,6 | 1,0 | 1,4 | 1,9 | 2,6 |
| 0 | 0,0 | 0,0 | 0,0 | 0,0 | 0,0 | 0,0 | 0,0 | 0,0 | 0,0 | 0,0 | 0,0 | 0,0 | 0,0 | 0,0 | 0,0 | 0,0 | 0,0 | 0,0 | 0,0 |
| -5 | -2,6 | -1,9 | -1,4 | -1,0 | -0,6 | -0,4 | -0,2 | -0,1 | 0,0 | 0,0 | 0,0 | 0,0 | -0,1 | -0,2 | -0,4 | -0,6 | -0,9 | -1,2 | -1,7 |
| -10 | -6,7 | -4,7 | -3,4 | -2,3 | -1,6 | -1,0 | -0,6 | -0,3 | -0,1 | 0,0 | 0,0 | 0,0 | -0,1 | -0,3 | -0,6 | -1,0 | -1,4 | -2,0 | -2,8 |
| -15 | -15,0 | -9,4 | -6,3 | -4,4 | -3,0 | -1,9 | -1,2 | -0,6 | -0,2 | 0,0 | 0,1 | 0,1 | 0,0 | -0,2 | -0,6 | -1,0 | -1,7 | -2,4 | -3,4 |
| -20 | #### | -20,0 | -11,3 | -7,4 | -4,9 | -3,2 | -1,9 | -1,0 | -0,4 | 0,0 | 0,2 | 0,3 | 0,2 | 0,0 | -0,4 | -0,9 | -1,6 | -2,5 | -3,6 |
| -25 | #### | #### | -25,0 | -12,3 | -7,7 | -4,9 | -3,0 | -1,6 | -0,6 | 0,0 | 0,4 | 0,6 | 0,6 | 0,4 | 0,0 | -0,6 | -1,3 | -2,3 | -3,5 |
| -30 | #### | #### | #### | -30,0 | -12,3 | -7,4 | -4,4 | -2,3 | -1,0 | 0,0 | 0,6 | 1,0 | 1,0 | 0,9 | 0,6 | 0,0 | -0,8 | -1,8 | -3,0 |
| -35 | #### | #### | #### | #### | -25,0 | -11,3 | -6,3 | -3,4 | -1,4 | 0,0 | 0,9 | 1,4 | 1,7 | 1,6 | 1,3 | 0,8 | 0,0 | -1,0 | -2,3 |
| -40 | #### | #### | #### | #### | #### | -20,0 | -9,4 | -4,7 | -1,9 | 0,0 | 1,2 | 2,0 | 2,4 | 2,5 | 2,3 | 1,8 | 1,0 | 0,0 | -1,3 |
| -45 | #### | #### | #### | #### | #### | #### | -15,0 | -6,7 | -2,6 | 0,0 | 1,7 | 2,8 | 3,4 | 3,6 | 3,5 | 3,0 | 2,3 | 1,3 | 0,0 |
| β [deg] | -45,0 | -40,0 | -35,0 | -30,0 | -25,0 | -20,0 | -15,0 | -10,0 | -5,0 | 0,0 | 5,0 | 10,0 | 15,0 | 20,0 | 25,0 | 30,0 | 35,0 | 40,0 | 45,0 |

91

FIG.9

| β [deg] | 10 | ψ [deg] | 10 | | | | | | | | | | | | | | | |
|---|---|---|---|---|---|---|---|---|---|---|---|---|---|---|---|---|---|---|
| θ [deg] | εΔα =Arcsin((sinθ.cosψ+sinα.cosβ)/(1-(sinψ+sinβ)^2)^0,5)-(θ+α) | | | | | | | | | | | | | | | | | | |
| 45 | 0,0 | -1,1 | -1,9 | -2,4 | -2,6 | -2,5 | -1,9 | -0,9 | 0,6 | 3,0 | 6,5 | 12,7 | #### | #### | #### | #### | #### | #### | #### |
| 40 | 1,1 | 0,0 | -0,8 | -1,4 | -1,6 | -1,6 | -1,2 | -0,5 | 0,7 | 2,5 | 5,0 | 9,0 | 16,2 | #### | #### | #### | #### | #### | #### |
| 35 | 1,9 | 0,8 | 0,0 | -0,6 | -0,9 | -0,9 | -0,7 | -0,2 | 0,7 | 2,0 | 3,9 | 6,7 | 10,9 | 19,1 | #### | #### | #### | #### | #### |
| 30 | 2,4 | 1,4 | 0,6 | 0,0 | -0,3 | -0,5 | -0,3 | 0,0 | 0,7 | 1,7 | 3,1 | 5,0 | 7,8 | 12,2 | 20,7 | #### | #### | #### | #### |
| 25 | 2,6 | 1,6 | 0,9 | 0,3 | 0,0 | -0,1 | -0,1 | 0,2 | 0,6 | 1,3 | 2,4 | 3,8 | 5,7 | 8,4 | 12,6 | 20,7 | #### | #### | #### |
| 20 | 2,5 | 1,6 | 0,9 | 0,5 | 0,1 | 0,0 | 0,0 | 0,2 | 0,5 | 1,0 | 1,8 | 2,8 | 4,1 | 5,9 | 8,4 | 12,2 | 19,1 | #### | #### |
| 15 | 1,9 | 1,2 | 0,7 | 0,3 | 0,1 | 0,0 | 0,0 | 0,1 | 0,4 | 0,8 | 1,3 | 2,0 | 2,9 | 4,1 | 5,7 | 7,8 | 10,9 | 16,2 | #### |
| 10 | 0,9 | 0,5 | 0,2 | 0,0 | -0,2 | -0,2 | -0,1 | 0,0 | 0,2 | 0,5 | 0,9 | 1,4 | 2,0 | 2,8 | 3,8 | 5,0 | 6,7 | 9,0 | 12,7 |
| 5 | -0,6 | -0,7 | -0,7 | -0,7 | -0,6 | -0,5 | -0,4 | -0,2 | 0,0 | 0,3 | 0,5 | 0,9 | 1,3 | 1,8 | 2,4 | 3,1 | 3,9 | 5,0 | 6,5 |
| 0 | -3,0 | -2,5 | -2,0 | -1,7 | -1,3 | -1,0 | -0,8 | -0,5 | -0,3 | 0,0 | 0,3 | 0,5 | 0,8 | 1,0 | 1,3 | 1,7 | 2,0 | 2,5 | 3,0 |
| -5 | -6,5 | -5,0 | -3,9 | -3,1 | -2,4 | -1,8 | -1,3 | -0,9 | -0,5 | -0,3 | 0,0 | 0,2 | 0,4 | 0,5 | 0,6 | 0,7 | 0,7 | 0,7 | 0,6 |
| -10 | -12,7 | -9,0 | -6,7 | -5,0 | -3,8 | -2,8 | -2,0 | -1,4 | -0,9 | -0,5 | -0,2 | 0,0 | 0,1 | 0,2 | 0,2 | 0,0 | -0,2 | -0,5 | -0,9 |
| -15 | #### | -16,2 | -10,9 | -7,8 | -5,7 | -4,1 | -2,9 | -2,0 | -1,3 | -0,8 | -0,4 | -0,1 | 0,0 | 0,0 | -0,1 | -0,3 | -0,7 | -1,2 | -1,9 |
| -20 | #### | #### | -19,1 | -12,2 | -8,4 | -5,9 | -4,1 | -2,8 | -1,8 | -1,0 | -0,5 | -0,2 | 0,0 | 0,0 | -0,1 | -0,5 | -0,9 | -1,6 | -2,5 |
| -25 | #### | #### | #### | -20,7 | -12,6 | -8,4 | -5,7 | -3,8 | -2,4 | -1,3 | -0,6 | -0,2 | 0,1 | 0,1 | 0,0 | -0,3 | -0,9 | -1,6 | -2,6 |
| -30 | #### | #### | #### | #### | -20,7 | -12,2 | -7,8 | -5,0 | -3,1 | -1,7 | -0,7 | 0,0 | 0,3 | 0,5 | 0,3 | 0,0 | -0,6 | -1,4 | -2,4 |
| -35 | #### | #### | #### | #### | #### | -19,1 | -10,9 | -6,7 | -3,9 | -2,0 | -0,7 | 0,2 | 0,7 | 0,9 | 0,9 | 0,6 | 0,0 | -0,8 | -1,9 |
| -40 | #### | #### | #### | #### | #### | #### | -16,2 | -9,0 | -5,0 | -2,5 | -0,7 | 0,5 | 1,2 | 1,6 | 1,6 | 1,4 | 0,8 | 0,0 | -1,1 |
| -45 | #### | #### | #### | #### | #### | #### | #### | -12,7 | -6,5 | -3,0 | -0,6 | 0,9 | 1,9 | 2,5 | 2,6 | 2,4 | 1,9 | 1,1 | 0,0 |
| α [deg] | -45,0 | -40,0 | -35,0 | -30,0 | -25,0 | -20,0 | -15,0 | -10,0 | -5,0 | 0,0 | 5,0 | 10,0 | 15,0 | 20,0 | 25,0 | 30,0 | 35,0 | 40,0 | 45,0 |

101

FIG.10

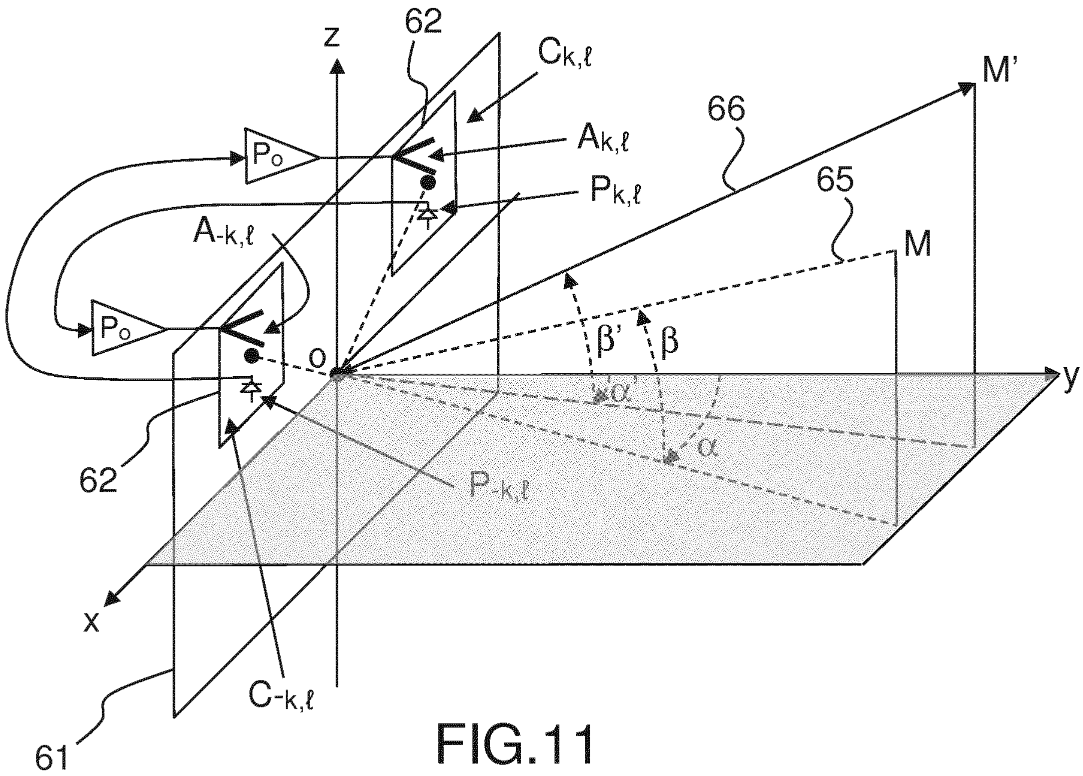
z
62
Ck,ℓ
M'
66
Po
Ak,ℓ
Pk,ℓ
65
A-k,ℓ
M
Po
β'
β
o
y
α'
α
62
P-k,ℓ
x
C-k,ℓ
61

FIG.11

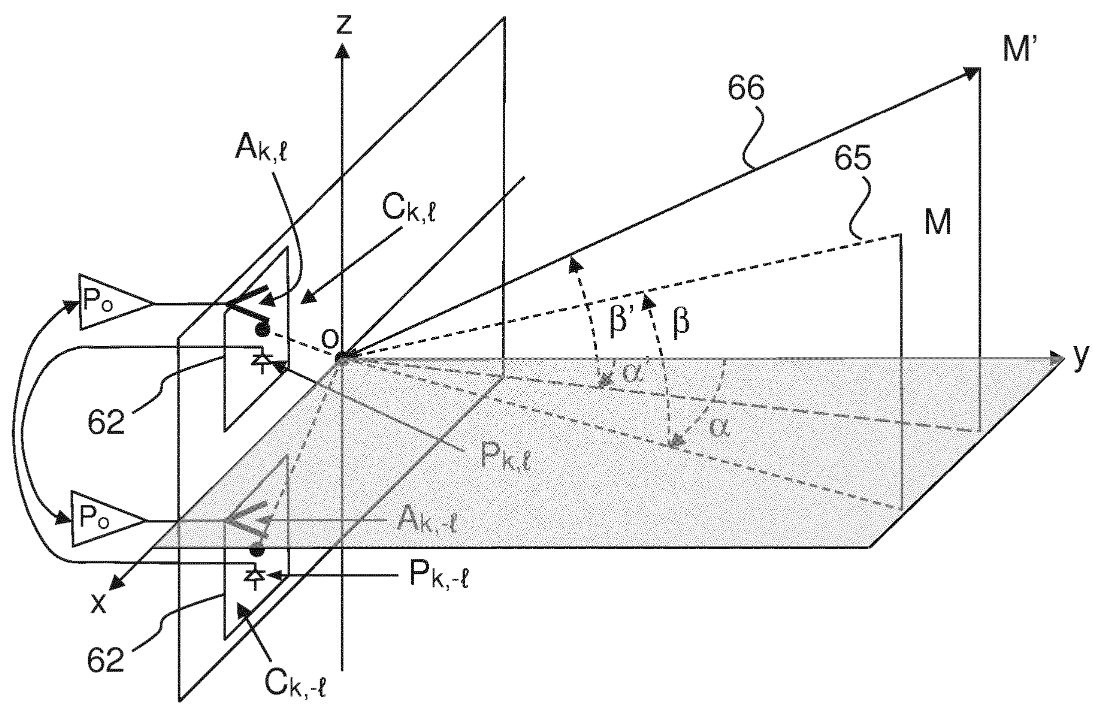
z
M'
66
Ak,ℓ
65
Ck,ℓ
M
Po
β'
β
o
y
α'
62
α
Pk,ℓ
Po
Ak,-ℓ
x
Pk,-ℓ
62
Ck,-ℓ

FIG.12

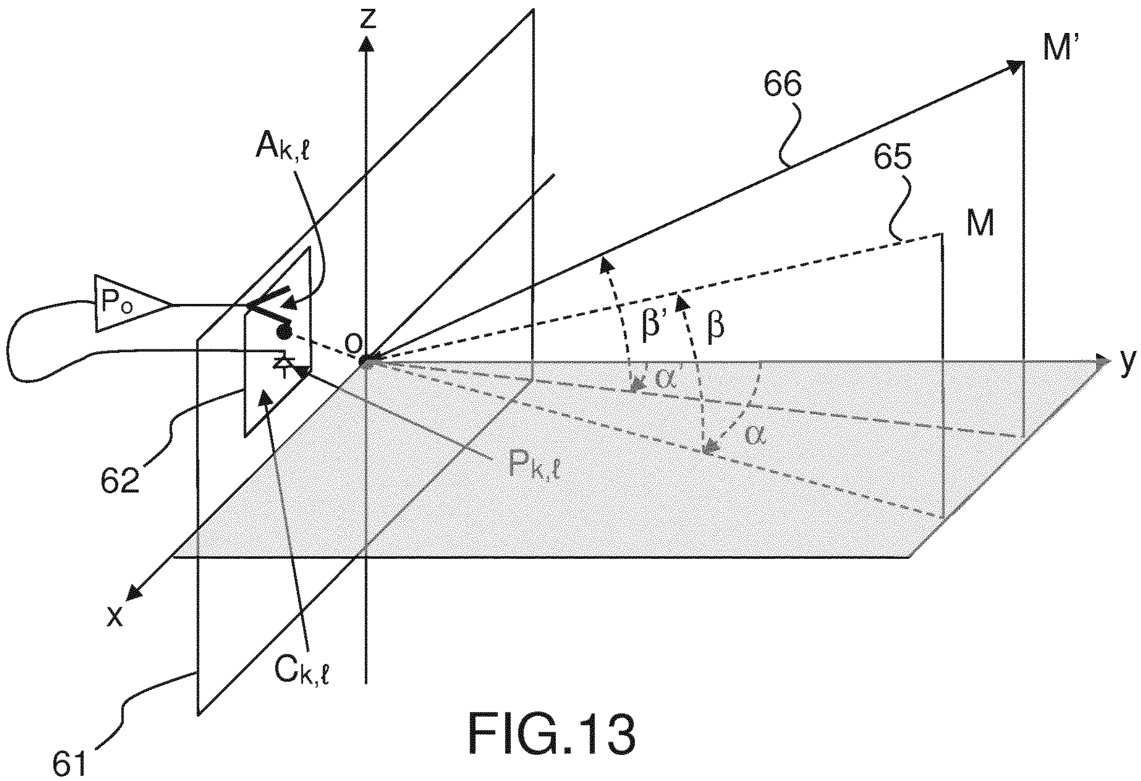
z
M'
66
Ak,ℓ
65
M
Po
β'
β
o
y
α'
α
62
Pk,ℓ
x
Ck,ℓ
61

FIG.13

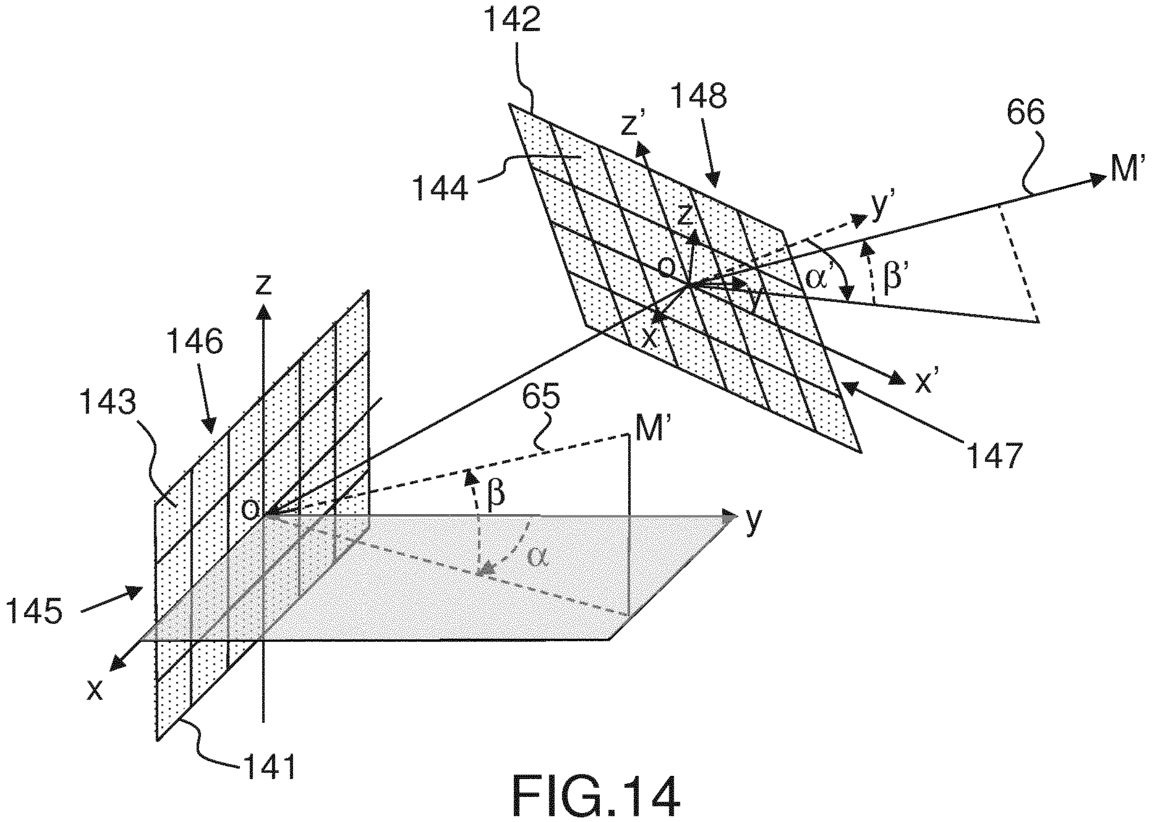
142
148
66
z'
M'
144
y'
z
o
α'
β'
y
x
x'
z
146
65
147
143
M'
β
o
y
α
145
x
141

FIG.14

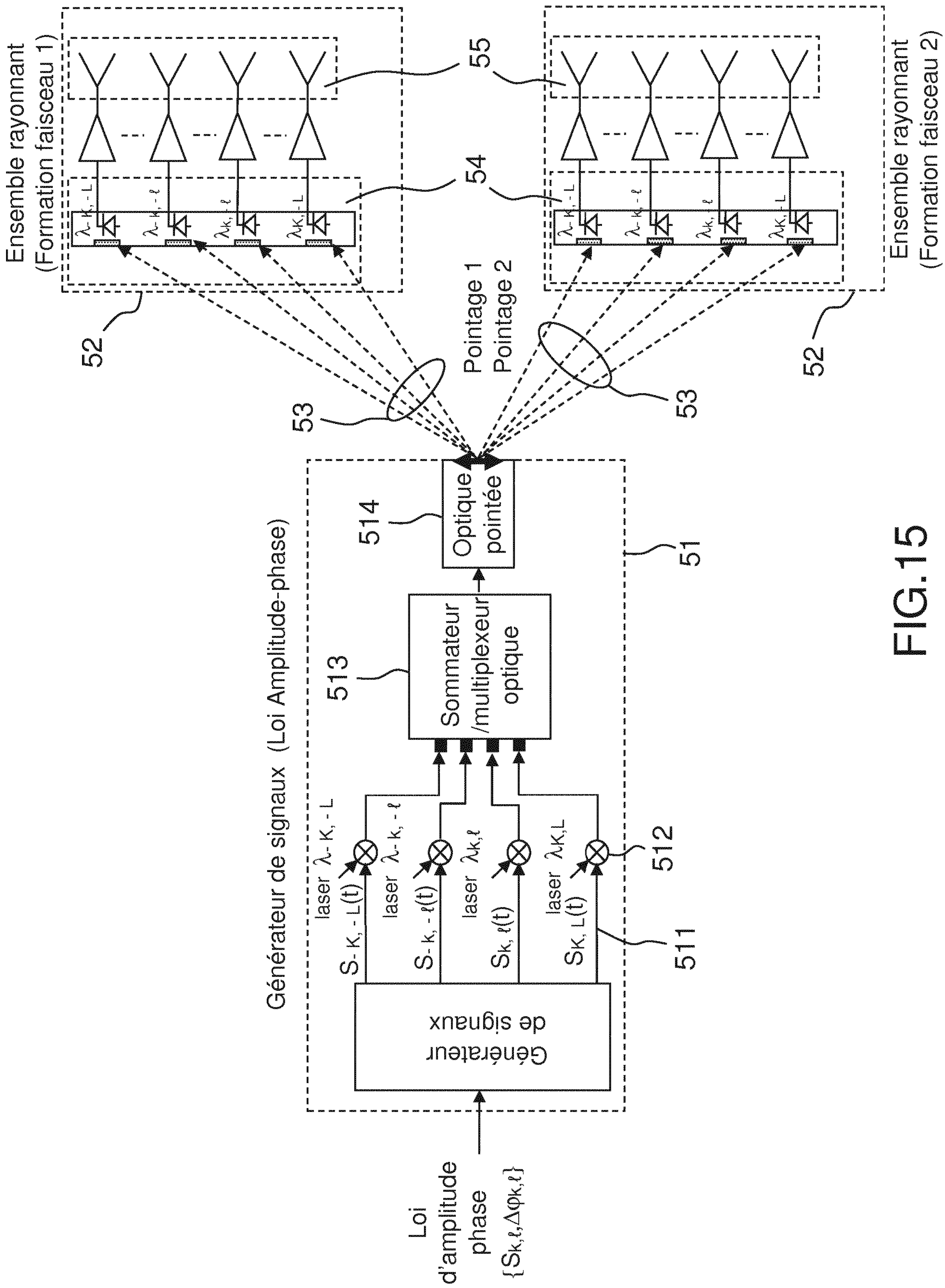
Ensemble rayonnant
(Formation faisceau 1)
Ensemble rayonnant
(Formation faisceau 2)
55
54
52
53
Pointage 1
Pointage 2
Générateur de signaux (Loi Amplitude-phase)
514
Optique
pointée
513
Sommateur
/multiplexeur
optique
51
512
511
Générateur
de signaux
Loi
d'amplitude
phase


FIG.15

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- WO 2015028091 A